# EUROPEAN PATENT APPLICATION

(11) **EP 4 714 990 A1**
(43) Date of publication of application: **25.03.2026**
(21) Application number: 24815616.8
(22) Date of filing: 31.05.2024
(51) Int. Cl.: C08F 220/22, C07C 31/42, C07C 67/08, C07C 69/653, C08F 220/38, G03F 7/004, G03F 7/20, G03F 7/038, G03F 7/039, H01L 21/027

(54) **COPOLYMER, POLYMER FOR WATER-REPELLENT AGENT, COMPOSITION FOR FORMING WATER-REPELLENT FILM, RESIN FILM, AND METHOD FOR FORMING RESIST PATTERN**

(30) Priority: 31.05.2023 JP 2023090233; 19.01.2024 JP 2024006975
(71) Applicant: Central Glass Company, Limited, Ube-shi, Yamaguchi 755-0001 (JP)
(72) Inventor: MASUBUCHI, Takashi, Tokyo 101-0054 (JP); KANEKO, Yuzuru, Tokyo 101-0054 (JP); IWATA, Hiromasa, Tokyo 101-0054 (JP)
(74) Representative: Manitz Finsterwald Patent- und Rechtsanwaltspartnerschaft mbB
(86) International application number: PCT/JP2024/020046
(87) International publication number: WO 2024/248136

(57) **Abstract**

Provided is a polymer capable of forming a resin film exhibiting low hysteresis with respect to an immersion fluid and low sliding angle in liquid immersion lithography. A copolymer of the present disclosure contains a repeating unit derived from a compound having a polymerizable carbon-carbon double bond, and a repeating unit of the formula (1): 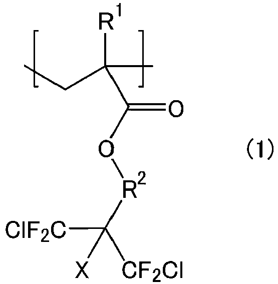 wherein R¹ is a hydrogen, fluorine, or chlorine atom, or a C1-C10 linear or C3-C10 branched alkyl group, some or all of the hydrogen atoms bonded to the carbon atoms in the alkyl group being optionally replaced by fluorine atoms; R² is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated; and X is a hydroxy or alkoxy group, or a hydrogen atom.

## Description

### TECHNICAL FIELD

The present disclosure relates to a copolymer, a polymer for a water repellent, a composition for forming a water-repellent film, a resin film, and a method for forming a resist pattern.

### BACKGROUND ART

In the field of microfabrication, typically integrated circuit device production, lithographic techniques capable of microfabrication are required to achieve higher levels of integration.

Liquid immersion lithography is known as such a lithographic technique.

Liquid immersion lithography refers to an exposure process performed with an immersion fluid that fills the space between the lens of an exposure apparatus and a substrate such as a silicon wafer.

When the space between the lens of an exposure apparatus and a substrate is filled with an immersion fluid, the incident angle of the exposure light entering the substrate through the lens can be reduced compared to when the space between the lens of the exposure apparatus and the substrate is filled with air. Thus, the numerical aperture of the lens can be increased, thereby improving the resolution (see Non-Patent Literature 1).

During patterning by liquid immersion lithography, a resist film is formed on the surface of a substrate, and the space between the resist film and the lens of an exposure apparatus is filled with an immersion fluid to perform an exposure process.

Generally, the immersion fluid used is water (pure water).

If the immersion fluid comes into contact with the resist film, the immersion fluid may penetrate into the resist film, causing patterning failure. Patterning failure may also occur due to the leaching of various components from the resist film into the immersion fluid. Further, after the liquid immersion lithography, fluid droplets may remain on the substrate, possibly resulting in patterning defects.

In a conventional method for liquid immersion lithography, an upper layer film is formed on a resist film to prevent such patterning failure and the like.

Patent Literatures 1 and 2 describe a method for forming such an upper layer film from a composition containing a fluorine-containing resin with a specific structure.

There is another conventional method in which a non-topcoat resist film is formed by adding a fluorine-containing resin as described in Patent Literature 1 or 2 to a resist film without forming an upper layer film, followed by liquid immersion lithography for patterning.

### CITATION LIST

### - Patent Literature

Patent Literature 1: JP 2008-65098 A
Patent Literature 2: JP 2022-92439 A

### - Non-Patent Literature

Non-Patent Literature 1: Advances in Patterning Materials for 193 nm Immersion Lithography, Chem. Rev. 2010, 110, 321-360

### SUMMARY OF INVENTION

### - Technical Problem

In high-speed exposure using an exposure apparatus, if the upper layer film or non-topcoat resist film has a high hysteresis (advancing contact angle - receding contact angle) with respect to the immersion fluid or a high sliding angle, the immersion fluid drains poorly during exposure, which increases the likelihood of patterning failure.

The upper layer film or non-topcoat resist film formed from a fluorine-containing resin as described in Patent Literature 1 or 2 still has room for improvement in terms of hysteresis with respect to the immersion fluid and sliding angle.

### - Solution to Problem

The present disclosure has been made to solve the above problems and aims to provide a polymer capable of forming a resin film having a low hysteresis with respect to an immersion fluid and a low sliding angle in liquid immersion lithography.

Embodiment (1) of the present disclosure relates to a copolymer, containing:
a repeating unit derived from a compound having a polymerizable carbon-carbon double bond, and
a repeating unit represented by the following formula (1): 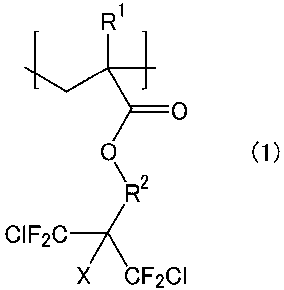 wherein R¹ is a hydrogen atom, a fluorine atom, a chlorine atom, or a C1-C10 linear or C3-C10 branched alkyl group, some or all of hydrogen atoms bonded to carbon atoms in the alkyl group being optionally replaced by fluorine atoms;
R² is a single bond, an alkylene group optionally having a linear, branched, or cyclic structure, an aromatic ring, an ester, a carbonyl, an ether, an amide, an amine, or a composite substituent thereof, a part of which is optionally fluorinated, chlorinated, or both fluorinated and chlorinated; and
X is a hydroxy group, an alkoxy group, or a hydrogen atom.

Embodiment (2) of the present disclosure relates to the copolymer according to Embodiment (1),
wherein the repeating unit represented by formula (1) includes a repeating unit represented by the following formula (2):

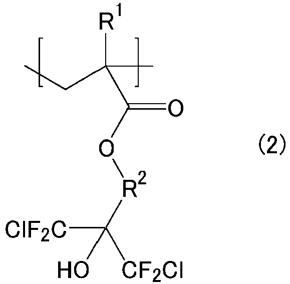

Embodiment (3) of the present disclosure relates to the copolymer according to Embodiment (2),
wherein the repeating unit represented by formula (2) includes a repeating unit represented by the following formula (2-1):

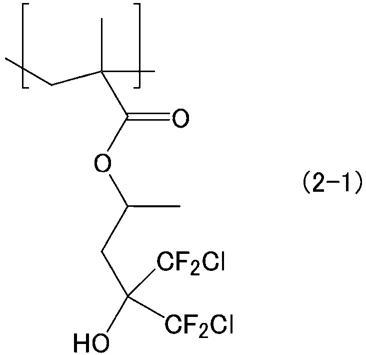

Embodiment (4) of the present disclosure relates to the copolymer according to Embodiment (1),
wherein the repeating unit represented by formula (1) includes a repeating unit represented by the following formula (3):

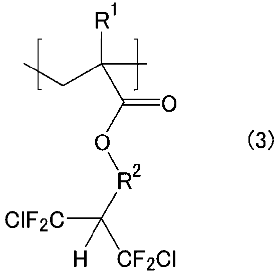

Embodiment (5) of the present disclosure relates to the copolymer according to Embodiment (4),
wherein the repeating unit represented by formula (3) includes a repeating unit represented by the following formula (3-1):

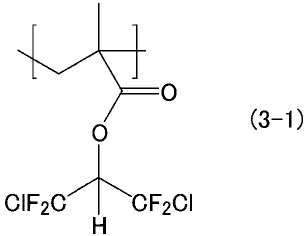

Embodiment (6) of the present disclosure relates to the copolymer according to any one of Embodiments (1) to (5),
wherein the repeating unit derived from a compound having a polymerizable carbon-carbon double bond includes a repeating unit represented by the following formula (4): 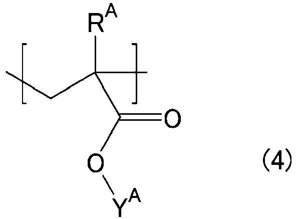 wherein R^{A} is a hydrogen atom, a fluorine atom, a chlorine atom, or a C1-C10 linear or C3-C10 branched alkyl group, some or all of hydrogen atoms bonded to carbon atoms in the alkyl group being optionally replaced by fluorine atoms; and
Y^{A} is a monovalent organic group.

Embodiment (7) of the present disclosure relates to the copolymer according to Embodiment (6),
wherein the repeating unit represented by formula (4) includes a repeating unit containing no fluorine atom.

Embodiment (8) of the present disclosure relates to the copolymer according to Embodiment (6) or (7),
wherein the repeating unit represented by formula (4) includes at least one repeating unit derived from at least one compound having a polymerizable carbon-carbon double bond selected from the group consisting of methyl methacrylate, ethyl methacrylate, n-propyl methacrylate, isopropyl methacrylate, n-butyl methacrylate, isobutyl methacrylate, t-butyl methacrylate, pentyl methacrylate, methyl acrylate, ethyl acrylate, n-propyl acrylate, isopropyl acrylate, n-butyl acrylate, isobutyl acrylate, t-butyl acrylate, pentyl acrylate, a compound represented by the following formula (4'-1), a compound represented by the following formula (4'-2), a compound represented by the following formula (4'-3), a compound represented by the following formula (4'-4), a compound represented by the following formula (4'-5), a compound represented by the following formula (4'-6), a compound represented by the following formula (4'-7), a compound represented by the following formula (4'-8), a compound represented by the following formula (4'-9), a compound represented by the following formula (4'-10), a compound represented by the following formula (4'-11), a compound represented by the following formula (4'-12), a compound represented by the following formula (4'-13), a compound represented by the following formula (4'-14), a compound represented by the following formula (4'-15), and a compound represented by the following formula (4'-16):

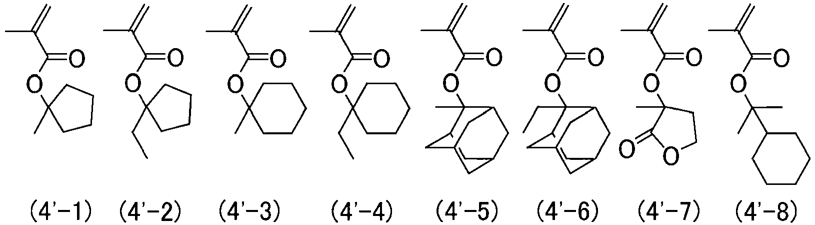

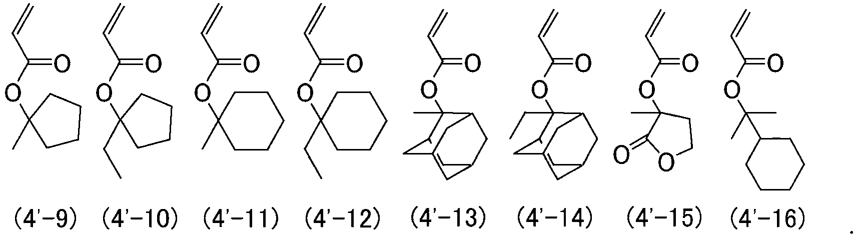

Embodiment (9) of the present disclosure relates to a polymer for a water repellent, containing a repeating unit represented by the following formula (1): 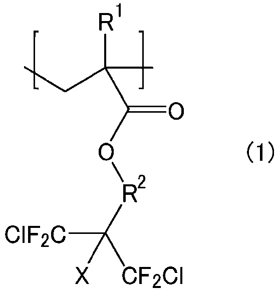 wherein R¹ is a hydrogen atom, a fluorine atom, a chlorine atom, or a C1-C10 linear or C3-C10 branched alkyl group, some or all of hydrogen atoms bonded to carbon atoms in the alkyl group being optionally replaced by fluorine atoms;
R² is a single bond, an alkylene group optionally having a linear, branched, or cyclic structure, an aromatic ring, an ester, a carbonyl, an ether, an amide, an amine, or a composite substituent thereof, a part of which is optionally fluorinated, chlorinated, or both fluorinated and chlorinated; and
X is a hydroxy group, an alkoxy group, or a hydrogen atom.

Embodiment (10) of the present disclosure relates to the polymer for a water repellent according to Embodiment (9),
wherein the repeating unit represented by formula (1) includes a repeating unit represented by the following formula (2):

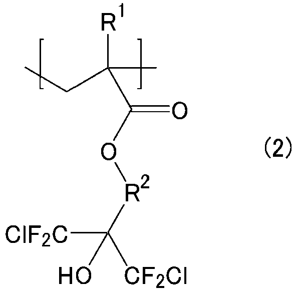

Embodiment (11) of the present disclosure relates to the polymer for a water repellent according to Embodiment (10),
wherein the repeating unit represented by formula (2) includes a repeating unit represented by the following formula (2-1):

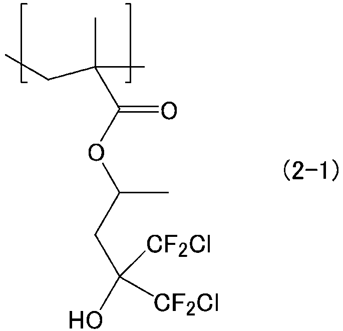

Embodiment (12) of the present disclosure relates to the polymer for a water repellent according to Embodiment (9),
wherein the repeating unit represented by formula (1) includes a repeating unit represented by the following formula (3):

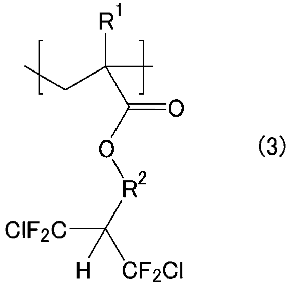

Embodiment (13) of the present disclosure relates to the polymer for a water repellent according to Embodiment (12),
wherein the repeating unit represented by formula (3) includes a repeating unit represented by the following formula (3-1):

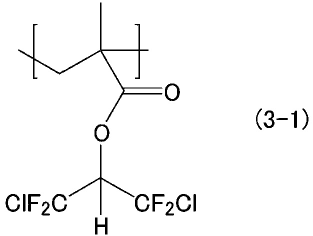

A composition for forming a water-repellent film according to Embodiment (14) of the present disclosure contains the copolymer according to any one of Embodiments (1) to (8) or the polymer for a water repellent according to any one of Embodiments (9) to (13).

A composition for forming a water-repellent film according to Embodiment (15) of the present disclosure is the composition for forming a water-repellent film according to Embodiment (14), containing two or more types of copolymers according to any one of Embodiments (1) to (8) or polymers for a water repellent according to any one of Embodiments (9) to (13).

A composition for forming a water-repellent film according to Embodiment (16) of the present disclosure is the composition for forming a water-repellent film according to Embodiment (14), further containing an acid generator.

A resin film according to Embodiment (17) of the present disclosure includes a coating film of the composition for forming a water-repellent film according to Embodiment (14).

A resin film according to Embodiment (18) of the present disclosure is the resin film according to Embodiment (17) for use in liquid immersion lithography.

A method for forming a resist pattern according to Embodiment (19) of the present disclosure includes:
a film formation step including applying the composition for forming a water-repellent film according to Embodiment (14) to a surface of a substrate or a lower layer film to form a resin film, and
a liquid immersion lithography step including exposing the resin film with a surface in direct contact with water to electromagnetic waves or high-energy rays having a wavelength of 300 nm or less through the water.

### - Advantageous Effects of Invention

The use of the polymer of the present disclosure enables the formation of a resin film having a low hysteresis with respect to an immersion fluid and a low sliding angle in liquid immersion lithography.

### DESCRIPTION OF EMBODIMENTS

Hereinafter, the present disclosure will be described in detail, but the description of the constituent elements described below illustrates embodiments of the present disclosure, and the present disclosure is not limited to these specific contents. Various modifications may be made within the scope of its gist.

In the section of the present specification entitled "DESCRIPTION OF EMBODIMENTS", the items indicated by "[" and "]" or "<" and ">" are merely symbols and do not have any meaning by themselves.

### (First Embodiment)

A copolymer according to a first embodiment of the present disclosure is described.

The copolymer according to the first embodiment of the present disclosure contains a repeating unit derived from a compound having a polymerizable carbon-carbon double bond, and a repeating unit represented by the following formula (1): 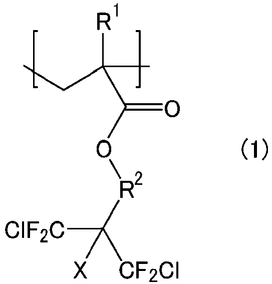 wherein R¹ is a hydrogen atom, a fluorine atom, a chlorine atom, or a C1-C10 linear or C3-C10 branched alkyl group, some or all of the hydrogen atoms bonded to the carbon atoms in the alkyl group being optionally replaced by fluorine atoms;
R² is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated; and
X is a hydroxy group, an alkoxy group, or a hydrogen atom.

The copolymer according to the first embodiment of the present disclosure is used to form an upper layer film or a non-topcoat resist film in liquid immersion lithography.

The upper layer film or non-topcoat resist film formed from the copolymer according to the first embodiment of the present disclosure has a low hysteresis with respect to an immersion fluid and a low sliding angle.

Thus, the immersion fluid can drain well during exposure, resulting in good patterning.

It should be noted that the repeating unit represented by formula (1) has a monochlorodifluoromethyl group (-CF₂Cl).

The repeating units in conventional polymers for forming an upper layer film or a non-topcoat resist film contain a trifluoromethyl group (-CF₃).

A monochlorodifluoromethyl group (-CF₂Cl) more easily decomposes than a trifluoromethyl group (-CF₃).

A waste liquid resulting from the formation of an upper layer film or a non-topcoat resist film from the copolymer according to the first embodiment of the present disclosure contains a resin with a monochlorodifluoromethyl group (-CF₂Cl).

The resin in such a waste liquid easily decomposes, thereby facilitating waste liquid disposal.

Examples of the alkyl group exemplified as R¹ include a methyl group, an ethyl group, and a propyl group such as a 1-propyl group or a 1-propyl group.

Examples of the alkylene group exemplified as R² include saturated acyclic hydrocarbon groups, including a methylene group, an ethylene group, a propylene group such as a 1,3-propylene group or a 1,2-propylene group, a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an insalene group, a 1-methyl-1,3-propylene group, a 2-methyl-1,3-propylene group, a 2-methyl-1,2-propylene group, a 1-methyl-1,4-butylene group, a 2-methyl-1,4-butylene group, a methylidene group, an ethylidene group, a propylidene group, and a 2-propylidene group; monocyclic hydrocarbon ring groups, including C3-C10 cycloalkylene groups such as a cyclobutylene group (e.g., a 1,3-cyclobutylene group), a cyclopentylene group (e.g., a 1,3-cyclopentylene group), a cyclohexylene group (e.g., a 1,4-cyclohexylene group), and a cyclooctylene group (e.g., a 1,5-cyclooctylene group); and bridged cyclic hydrocarbon ring groups, including bi- to tetracyclic hydrocarbon ring groups such as a norbornylene group (e.g., a 1,4-norbornylene group or a 2,5-norbornylene group) and an adamantylene group (e.g., a 1,5-adamantylene group or a 2,6-adamantylene group).

The amide exemplified as R² has a structure represented by -C(=O)NA-wherein A represents a hydrogen atom or a monovalent organic group.

The ether exemplified as R² has a structure represented by -O-.

The amine exemplified as R² has a structure represented by -NB- wherein B represents a hydrogen atom or a monovalent organic group.

The repeating unit represented by formula (1) may include a repeating unit represented by the following formula (2):

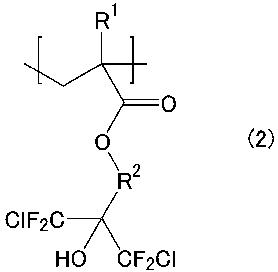

In the case where the repeating unit represented by formula (2) is present, the copolymer may have properties such as water repellency, adhesion, and alkali solubility due to the presence of a hydroxy group at the end of a side chain.

Examples of the repeating unit represented by formula (2) include a repeating unit represented by the following formula (2-1):

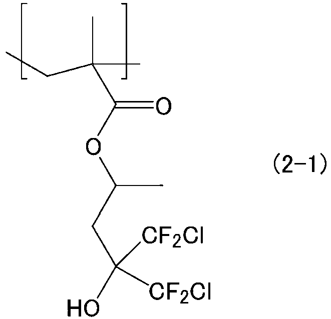

Moreover, the repeating unit represented by formula (1) may include a repeating unit represented by the following formula (3):

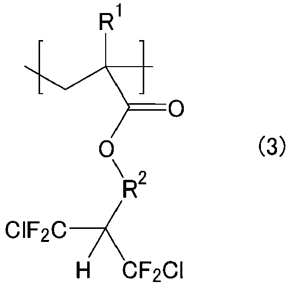

In the case where the repeating unit represented by formula (3) is present, the copolymer may have properties such as water repellency and water resistance due to the presence of a hydrogen group at the end of a side chain.

Examples of the repeating unit represented by formula (3) include a repeating unit represented by the following formula (3-1):

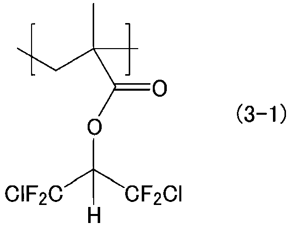

In the copolymer according to the first embodiment of the present disclosure, the repeating unit derived from a compound having a polymerizable carbon-carbon double bond refers to a repeating unit derived from a compound having a polymerizable carbon-carbon double bond, excluding the repeating unit represented by formula (1).

The repeating unit derived from a compound having a polymerizable carbon-carbon double bond may include, for example, a repeating unit represented by the following formula (4): 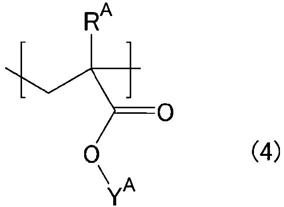 wherein R^{A} is a hydrogen atom, a fluorine atom, a chlorine atom, or a C1-C10 linear or C3-C10 branched alkyl group, some or all of the hydrogen atoms bonded to the carbon atoms in the alkyl group being optionally replaced by fluorine atoms; and Y^{A} is a monovalent organic group.

Examples of the alkyl group exemplified as R^{A} include a methyl group, an ethyl group, and a propyl group such as a 1-propyl group or a 2-propyl group.

Examples of the monovalent organic group exemplified as Y^{A} include C1-C30 alkyl groups, C2-C30 alkenyl groups, C2-C30 alkynyl groups, C6-C30 phenyl groups, and a naphthyl group, each of which may have a linear, branched, or cyclic structure, and the hydrogen atoms of the foregoing groups may be replaced by a fluorine atom, an oxygen atom, or a nitrogen atom, and the foregoing groups may contain a hydroxy group, an ester, a lactone, a carbonyl, an ether, an amide, an amine, or a composite substituent thereof.

It should be noted that the repeating unit represented by formula (4) is preferably a repeating unit containing no fluorine atom.

Moreover, the repeating unit represented by formula (4) may be a repeating unit represented by the following formula (4a).

The copolymer according to the first embodiment of the present disclosure containing a repeating unit represented by the following formula (4a) may have properties such as water repellency, water resistance, removal of acid-dissociable groups by an acid generated during exposure, and resultant alkali solubility.

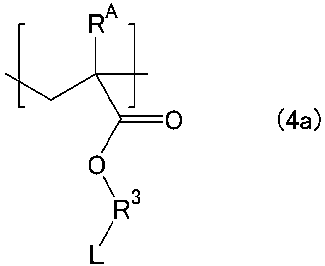

In formula (4a), R³ is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated; and L is an acid-dissociable group.

Examples of the alkylene group include saturated acyclic hydrocarbon groups, including a methylene group, an ethylene group, a propylene group such as a 1,3-propylene group or a 1,2-propylene group, a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an insalene group, a 1-methyl-1,3-propylene group, a 2-methyl-1,3-propylene group, a 2-methyl-1,2-propylene group, a 1-methyl-1,4-butylene group, a 2-methyl-1,4-butylene group, a methylidene group, an ethylidene group, a propylidene group, and a 2-propylidene group; monocyclic hydrocarbon ring groups, including C3-C10 cycloalkylene groups such as a cyclobutylene group (e.g., a 1,3-cyclobutylene group), a cyclopentylene group (e.g., a 1,3-cyclopentylene group), a cyclohexylene group (e.g., a 1,4-cyclohexylene group), and a cyclooctylene group (e.g., a 1,5-cyclooctylene group); and bridged cyclic hydrocarbon ring groups, including bi- to tetracyclic hydrocarbon ring groups such as a norbornylene group (e.g., a 1,4-norbornylene group or a 2,5-norbornylene group) and an adamantylene group (e.g., a 1,5-adamantylene group or a 2,6-adamantylene group).

Examples of the aromatic ring include an o-phenylene group, a m-phenylene group, and a p-phenylene group.

Examples of the acid-dissociable group include a tert-butyl group, a tert-amyl group, a 1,1-dimethylpropyl group, a 1-ethyl-1-methylpropyl group, a 1,1-dimethylbutyl group, an allyl group, a 1-pyrenylmethyl group, a 5-dibenzosuberyl group, a triphenylmethyl group, a 1-ethyl-1-methylbutyl group, a 1,1-diethylpropyl group, a 1,1-dimethyl-1-phenylmethyl group, a 1-methyl-1-ethyl-1-phenylmethyl group, a 1,1-diethyl-1-phenylmethyl group, a 1-methylcyclohexyl group, a 1-ethylcyclohexyl group, a 1-methylcyclopentyl group, a 1-ethylcyclopentyl group, a 1-isobornyl group, a 1-methyladamantyl group, a 1-ethyladamantyl group, a 1-isopropyladamantyl group, a 1-isopropylnorbornyl group, a 1-isopropyl-(4-methylcyclohexyl) group, a tert-butoxycarbonyl group, a tert-amyloxycarbonyl group, a methoxycarbonyl group, an ethoxycarbonyl group, an i-propoxycarbonyl group, a methoxymethyl group, an ethoxyethyl group, a butoxyethyl group, a cyclohexyloxyethyl group, a benzyloxyethyl group, a phenethyloxyethyl group, an ethoxypropyl group, a benzyloxypropyl group, a phenethyloxypropyl group, an ethoxybutyl group, an ethoxyisobutyl group, a trimethylsilyl group, an ethyldimethylsilyl group, a methyldiethylsilyl group, a triethylsilyl group, an i-propyldimethylsilyl group, a methyldi-i-propylsilyl group, a tri-i-propylsilyl group, a tert-butyldimethylsilyl group, a methyldi-tert-butylsilyl group, a tri-tert-butylsilyl group, a phenyldimethylsilyl group, a methyldiphenylsilyl group, a triphenylsilyl group, an acetyl group, a propionyl group, a butyryl group, a heptanoyl group, a hexanoyl group, a valeryl group, a pivaloyl group, an isovaleryl group, a lauroyl group, a myristoyl group, a palmitoyl group, a stearoyl group, an oxalyl group, a malonyl group, a succinyl group, a glutaryl group, an adipoyl group, a piperoyl group, a suberoyl group, an azelaoyl group, a sebacoyl group, a (meth)acryloyl group, a propioloyl group, a crotonoyl group, an oleoyl group, a maleoyl group, a fumaroyl group, a mesaconoyl group, a camphoroyl group, a benzoyl group, a phthaloyl group, an isophthaloyl group, a terephthaloyl group, a naphthoyl group, a toluoyl group, a hydroatropoyl group, an atropoyl group, a cinnamoyl group, a furoyl group, a thenoyl group, a nicotinoyl group, and an isonicotinoyl group.

Specifically, the repeating unit represented by formula (4) may be at least one repeating unit derived from at least one compound having a polymerizable carbon-carbon double bond selected from the group consisting of methyl methacrylate, ethyl methacrylate, n-propyl methacrylate, isopropyl methacrylate, n-butyl methacrylate, isobutyl methacrylate, t-butyl methacrylate, pentyl methacrylate, methyl acrylate, ethyl acrylate, n-propyl acrylate, isopropyl acrylate, n-butyl acrylate, isobutyl acrylate, t-butyl acrylate, pentyl acrylate, a compound represented by the following formula (4'-1), a compound represented by the following formula (4'-2), a compound represented by the following formula (4'-3), a compound represented by the following formula (4'-4), a compound represented by the following formula (4'-5), a compound represented by the following formula (4'-6), a compound represented by the following formula (4'-7), a compound represented by the following formula (4'-8), a compound represented by the following formula (4'-9), a compound represented by the following formula (4'-10), a compound represented by the following formula (4'-11), a compound represented by the following formula (4'-12), a compound represented by the following formula (4'-13), a compound represented by the following formula (4'-14), a compound represented by the following formula (4'-15), and a compound represented by the following formula (4'-16):

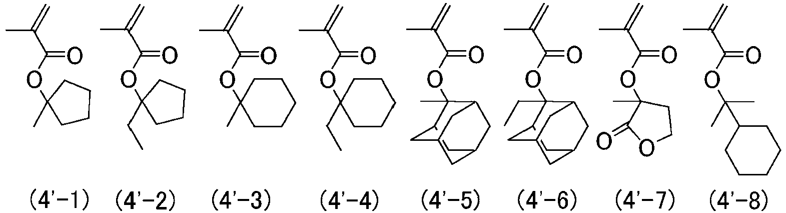

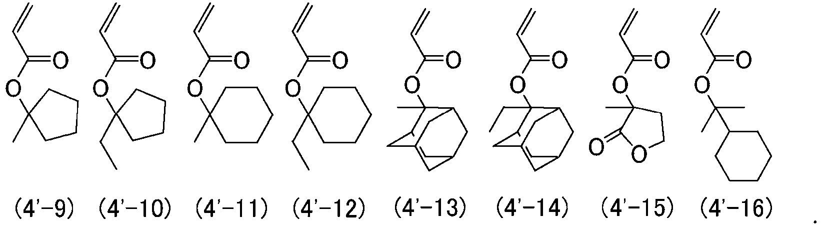

Specific preferred examples of the repeating unit represented by formula (4) include repeating units represented by the following chemical formulae:

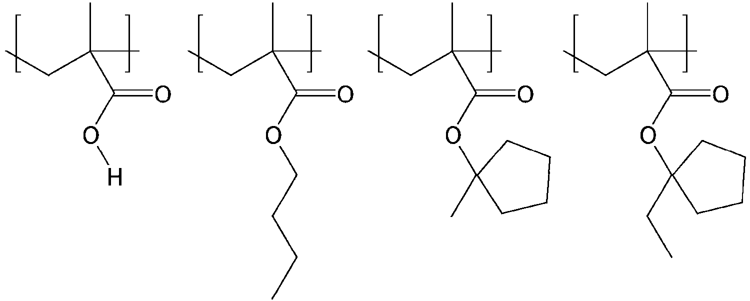

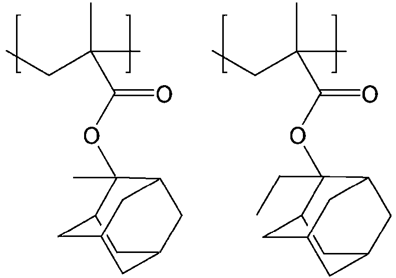

Moreover, the repeating unit derived from a compound having a polymerizable carbon-carbon double bond may include, for example, a repeating unit represented by the following formula (5).

The copolymer according to the first embodiment of the present disclosure containing a repeating unit represented by the following formula (5) may have properties such as alkali solubility and is therefore suitable for use in an upper layer film of a resist used in a liquid immersion lithography process.

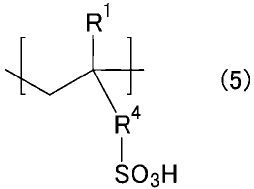

In formula (5), R⁴ is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated.

Examples of the alkylene group exemplified as R⁴ include saturated acyclic hydrocarbon groups, including a methylene group, an ethylene group, a propylene group such as a 1,3-propylene group or a 1,2-propylene group, a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an insalene group, a 1-methyl-1,3-propylene group, a 2-methyl-1,3-propylene group, a 2-methyl-1,2-propylene group, a 1-methyl-1,4-butylene group, a 2-methyl-1,4-butylene group, a methylidene group, an ethylidene group, a propylidene group, and a 2-propylidene group; monocyclic hydrocarbon ring groups, including C3-C10 cycloalkylene groups such as a cyclobutylene group (e.g., a 1,3-cyclobutylene group), a cyclopentylene group (e.g., a 1,3-cyclopentylene group), a cyclohexylene group (e.g., a 1,4-cyclohexylene group), and a cyclooctylene group (e.g., a 1,5-cyclooctylene group); and bridged cyclic hydrocarbon ring groups, including bi- to tetracyclic hydrocarbon ring groups such as a norbornylene group (e.g., a 1,4-norbornylene group or a 2,5-norbornylene group) and an adamantylene group (e.g., a 1,5-adamantylene group or a 2,6-adamantylene group).

Examples of the aromatic ring exemplified as R⁴ include an o-phenylene group, a m-phenylene group, and a p-phenylene group.

Moreover, the repeating unit derived from a compound having a polymerizable carbon-carbon double bond may contain an acid-decomposable group.

When such a copolymer is used to form a resin film on a substrate, exposing the resin film to electromagnetic waves or high-energy rays (such as electron beams) having a wavelength of 300 nm or less causes the acid-decomposable group to decompose, generating an acid in the resin film. This acid can improve the solubility of the exposed portion of the resin film in an alkaline developer during development.

As long as the copolymer according to the first embodiment of the present disclosure includes the repeating unit represented by formula (1) and the repeating unit derived from a compound having a polymerizable carbon-carbon double bond, the copolymer may include one type or multiple types of repeating units represented by formula (1) and may include one type or multiple types of repeating units derived from compounds having a polymerizable carbon-carbon double bond.

In the copolymer according to the first embodiment of the present disclosure containing multiple types of repeating units represented by formula (1), R¹ in each repeating unit may be the same or different. The same applies to R² and X.

In the copolymer according to the first embodiment of the present disclosure containing multiple types of repeating units represented by formula (4), R^{A} in each repeating unit may be the same or different. The same applies to Y^{A}.

In the copolymer according to the first embodiment of the present disclosure containing multiple types of repeating units represented by formula (4a), R^{A} in each repeating unit may be the same or different. The same applies to R³ and L.

In the copolymer according to the first embodiment of the present disclosure containing multiple types of repeating units represented by formula (5), R⁴ in each repeating unit may be the same or different.

Moreover, in the copolymer according to the first embodiment of the present disclosure containing at least two repeating units selected from repeating units represented by formula (1) and repeating units represented by formula (2), R¹ in each repeating unit may be the same or different.

Moreover, as long as the copolymer according to the first embodiment of the present disclosure contains the repeating unit represented by formula (1) and the repeating unit derived from a compound having a polymerizable carbon-carbon double bond, it may contain a repeating unit other than the above-described repeating units.

When all repeating units in the copolymer according to the first embodiment of the present disclosure are taken as 100 mol%, the proportion of repeating units represented by formula (1) may be 22 mol% or higher and 99 mol% or lower, may be 30 mol% or higher and 95 mol% or lower, or may even be 40 mol% or higher and 90 mol% or lower.

The weight average molecular weight of the copolymer according to the first embodiment of the present disclosure may be 5000 to 20000 or may even be 7000 to 12000. Herein, the weight average molecular weight of the polymer means the numerical value measured by gel permeation chromatography (GPC) under the following conditions.

### [GPC Conditions]

Apparatus: HLC-8320GPC manufactured by Tosoh Corporation
Columns for polymerizable monomer analysis: TSKgel series manufactured by Tosoh Corporation (G2500HXL, G2000HXL, G1000HXL, and G1000HXL connected in series in that order)
Columns for polymer analysis: TSKgel series manufactured by Tosoh Corporation (G2500HXL, G2000HXL, G1000HXL, and G1000HXL connected in series in that order)
Temperature program: 40°C (retention)
Flow rate: 1 mL/min
Detector: differential refractometer (RI)
Eluent: tetrahydrofuran (THF)
Reference materials: polystyrene standard solutions

Next, an exemplary method for producing the copolymer according to the first embodiment of the present disclosure is described.

The method for producing the copolymer according to the first embodiment of the present disclosure includes a step of providing a fluorine-containing polymerizable monomer, a step of providing a compound having a polymerizable carbon-carbon double bond, and a polymerization step.

### <Step of Providing Fluorine-Containing Polymerizable Monomer>

In the method for producing the copolymer according to the first embodiment of the present disclosure, first, a compound represented by the following formula (6) is provided.

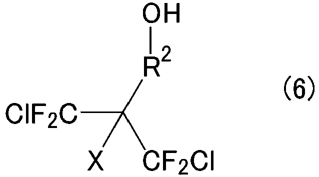

In formula (6), R² is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated; and X is a hydroxy group, an alkoxy group, or a hydrogen atom.

Subsequently, the compound represented by formula (6) is reacted with at least one selected from the group consisting of an acid halide, an acid anhydride, an ester, and a carboxylic acid.

Examples of the acid halide include methacryloyl chloride, methacryloyl bromide, methacryloyl fluoride, acryloyl chloride, acryloyl bromide, and acryloyl fluoride. Examples of the acid anhydride include methacrylic anhydride and acrylic anhydride. Examples of the ester include methyl methacrylate, ethyl methacrylate, methyl acrylate, butyl acrylate, n-propyl acrylate, iso-propyl acrylate, n-butyl acrylate, iso-butyl acrylate, sec-butyl acrylate, tert-butyl acrylate, n-propyl methacrylate, iso-propyl methacrylate, n-butyl methacrylate, iso-butyl methacrylate, sec-butyl methacrylate, and tert-butyl methacrylate. Examples of the carboxylic acid include methacrylic acid and acrylic acid.

The reaction between the compound represented by formula (6) and any of these compounds may be performed with the addition of an acid or a base, as necessary. Also, the reaction conditions are preferably 0°C to 130°C for 0.5 to 10 hours.

The separation and purification of the product after the reaction may be carried out by a conventional method. For example, concentration, distillation, extraction, recrystallization, filtration, column chromatography, and other methods can be used, and two or more methods may be used in combination.

A fluorine-containing polymerizable monomer represented by the following formula (7) can be produced through the above steps. The fluorine-containing polymerizable monomer represented by formula (7) is a compound corresponding to the repeating unit represented by formula (1) in the copolymer according to the first embodiment of the present disclosure.

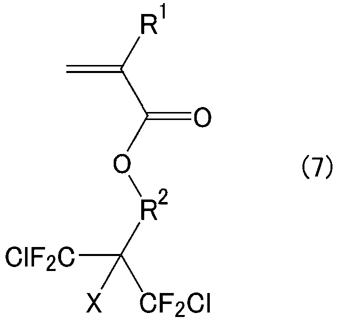

In formula (7), R¹ is a hydrogen atom, a fluorine atom, a chlorine atom, or a C1-C10 linear or C3-C10 branched alkyl group, some or all of the hydrogen atoms bonded to the carbon atoms in the alkyl group being optionally replaced by fluorine atoms;
R² is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated; and X is a hydroxy group, an alkoxy group, or a hydrogen atom.

### <Step of Providing Compound Having Polymerizable Carbon-Carbon Double Bond>

Next, a compound having a polymerizable carbon-carbon double bond is provided. Here, the compound having a polymerizable carbon-carbon double bond means a compound having a polymerizable carbon-carbon double bond other than the fluorine-containing polymerizable monomer represented by formula (7).

Examples of the compound having a polymerizable carbon-carbon double bond include a compound represented by the following formula (8): 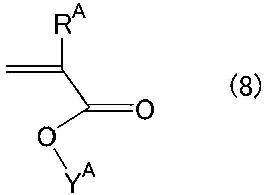 wherein R^{A} is a hydrogen atom, a fluorine atom, a chlorine atom, or a C1-C10 linear or C3-C10 branched alkyl group, some or all of the hydrogen atoms bonded to the carbon atoms in the alkyl group being optionally replaced by fluorine atoms; and
Y^{A} is a monovalent organic group.

The compound represented by formula (8) preferably contains no fluorine atom. Specific examples include methyl methacrylate, ethyl methacrylate, n-propyl methacrylate, isopropyl methacrylate, n-butyl methacrylate, isobutyl methacrylate, t-butyl methacrylate, pentyl methacrylate, methyl acrylate, ethyl acrylate, n-propyl acrylate, isopropyl acrylate, n-butyl acrylate, isobutyl acrylate, t-butyl acrylate, pentyl acrylate, a compound represented by the following formula (4'-1), a compound represented by the following formula (4'-2), a compound represented by the following formula (4'-3), a compound represented by the following formula (4'-4), a compound represented by the following formula (4'-5), a compound represented by the following formula (4'-6), a compound represented by the following formula (4'-7), a compound represented by the following formula (4'-8), a compound represented by the following formula (4'-9), a compound represented by the following formula (4'-10), a compound represented by the following formula (4'-11), a compound represented by the following formula (4'-12), a compound represented by the following formula (4'-13), a compound represented by the following formula (4'-14), a compound represented by the following formula (4'-15), and a compound represented by the following formula (4'-16).

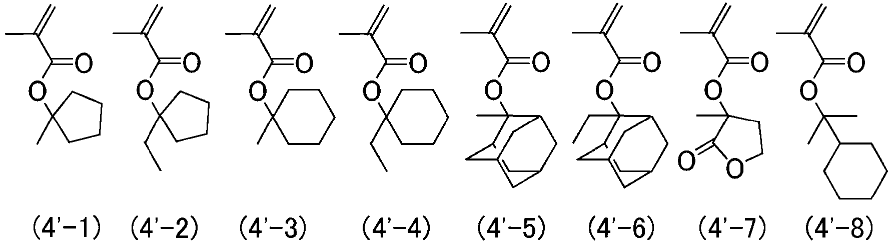

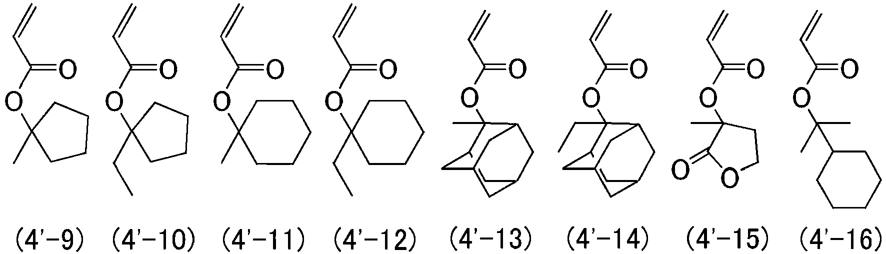

### <Polymerization Step>

Next, the fluorine-containing polymerizable monomer represented by formula (7) is polymerized with the compound having a polymerizable carbon-carbon double bond.

The reaction during the polymerization is not limited and may be a radical polymerization reaction, an ionic polymerization reaction, a coordination anionic polymerization reaction, a living anionic polymerization reaction, or a cationic polymerization reaction. A radical polymerization reaction is preferred among these.

When the polymerization reaction is a radical polymerization reaction, any polymerization initiator that can cause a polymerization reaction can be used, such as an azo compound, a peroxide compound, or a redox compound.

Examples of the azo compound include azobisisobutyronitrile. Examples of the peroxide compound include t-butyl peroxypivalate, di-t-butyl peroxide, i-butyryl peroxide, lauroyl peroxide, succinic acid peroxide, dicinnamyl peroxide, di-n-propyl peroxydicarbonate, t-butyl peroxyallyl monocarbonate, benzoyl peroxide, hydrogen peroxide, and ammonium persulfate.

Examples of the redox compound include combinations of oxidizing agents and reducing agents, in which the oxidizing agents include hydrogen peroxide, persulfates, cumene hydroperoxide, etc., while the reducing agents include iron(II) ion salts, copper(I) ion salts, ammonia, triethylamine, etc.

In the radical polymerization reaction, a polymerization solvent may also be used.

Any polymerization solvent that does not inhibit the radical polymerization reaction can be used, and it may be either an organic solvent or water. Examples of the organic solvent include hydrocarbon solvents, ester solvents, ketone solvents, alcohol solvents, ether solvents, cyclic ether solvents, fluorocarbon solvents, and aromatic solvents. Only one of these solvents may be used, or two or more thereof may be used in combination.

Examples of the ester solvents include acetic acid and n-butyl acetate.

Examples of the ketone solvents include acetone and methyl isobutyl ketone.

Examples of the hydrocarbon solvents include toluene and cyclohexane.

Examples of the alcohol solvents include methanol, isopropyl alcohol, and ethylene glycol monomethyl ether.

In the radical polymerization reaction, a molecular weight modifier such as mercaptan may also be used.

Although the reaction temperature in the radical polymerization reaction may be varied as appropriate depending on the radical polymerization initiator or the type of radical polymerization initiator, it is preferably 20°C or higher and 200°C or lower, more preferably 30°C or higher and 140°C or lower.

Following the polymerization step, a known method can be used to remove the medium, either organic solvent or water, from the solution or dispersion containing the synthesized copolymer. Specific examples of such methods include reprecipitation, filtration, and heating distillation under reduced pressure.

The copolymer according to the first embodiment of the present disclosure can be produced through the above steps.

### (Second Embodiment)

A polymer for a water repellent according to a second embodiment of the present disclosure is described.

The polymer for a water repellent according to the second embodiment of the present disclosure contains a repeating unit represented by the following formula (1): 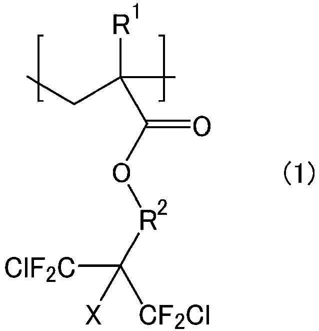 wherein R¹ is a hydrogen atom, a fluorine atom, a chlorine atom, or a C1-C10 linear or C3-C10 branched alkyl group, some or all of the hydrogen atoms bonded to the carbon atoms in the alkyl group being optionally replaced by fluorine atoms;
R² is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated; and
X is a hydroxy group, an alkoxy group, or a hydrogen atom.

A resin film formed from the polymer for a water repellent according to the second embodiment of the present disclosure has high water repellency. In other words, the polymer for a water repellent according to the second embodiment of the present disclosure is suitable for use in a water repellent.

It should be noted that the repeating unit represented by formula (1) contains a chlorodifluoromethyl group (-CF₂Cl).

The repeating units in conventional polymers for forming an upper layer film or a non-topcoat resist film contain a trifluoromethyl group (-CF₃).

A chlorodifluoromethyl group (-CF₂Cl) more easily decomposes than a trifluoromethyl group (-CF₃).

Thus, the resin film formed from the polymer for a water repellent according to the second embodiment of the present disclosure more easily decomposes than the resin films formed from conventional polymers. It is therefore possible to reduce the energy required for decomposing and disposing of the resin film.

Examples of the alkyl group exemplified as R¹ include a methyl group, an ethyl group, and a propyl group such as a 1-propyl group or a 2-propyl group.

Examples of the alkylene group exemplified as R² include saturated acyclic hydrocarbon groups, including a methylene group, an ethylene group, a propylene group such as a 1,3-propylene group or a 1,2-propylene group, a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an insalene group, a 1-methyl-1,3-propylene group, a 2-methyl-1,3-propylene group, a 2-methyl-1,2-propylene group, a 1-methyl-1,4-butylene group, a 2-methyl-1,4-butylene group, a methylidene group, an ethylidene group, a propylidene group, and a 2-propylidene group; monocyclic hydrocarbon ring groups, including C3-C10 cycloalkylene groups such as a cyclobutylene group (e.g., a 1,3-cyclobutylene group), a cyclopentylene group (e.g., a 1,3-cyclopentylene group), a cyclohexylene group (e.g., a 1,4-cyclohexylene group), and a cyclooctylene group (e.g., a 1,5-cyclooctylene group); and bridged cyclic hydrocarbon ring groups, including bi- to tetracyclic hydrocarbon ring groups such as a norbornylene group (e.g., a 1,4-norbornylene group or a 2,5-norbornylene group) and an adamantylene group (e.g., a 1,5-adamantylene group or a 2,6-adamantylene group).

The amide exemplified as R² has a structure represented by -C(=O)NA-wherein A represents a hydrogen atom or a monovalent organic group.

The ether exemplified as R² has a structure represented by -O-.

The amine exemplified as R² has a structure represented by -NB- wherein B represents a hydrogen atom or a monovalent organic group.

The repeating unit represented by formula (1) may include a repeating unit represented by the following formula (2):

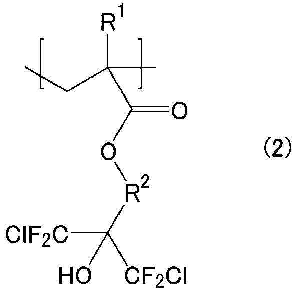

In the case where the repeating unit represented by formula (2) is present, the polymer for a water repellent may have properties such as water repellency, adhesion, and alkali solubility due to the presence of a hydroxy group at the end of a side chain.

Examples of the repeating unit represented by formula (2) include a repeating unit represented by the following formula (2-1):

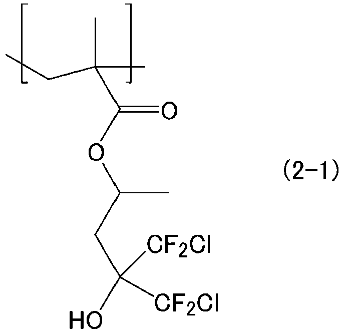

Moreover, the repeating unit represented by formula (1) may include a repeating unit represented by the following formula (3):

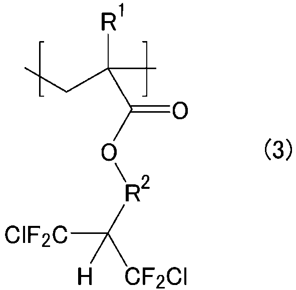

In the case where the repeating unit represented by formula (3) is present, the polymer for a water repellent may have properties such as water repellency and water resistance due to the presence of a hydrogen group at the end of a side chain.

Examples of the repeating unit represented by formula (3) include a repeating unit represented by the following formula (3-1):

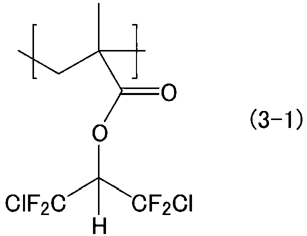

The polymer for a water repellent according to the second embodiment of the present disclosure may include only one type of repeating unit represented by formula (1) or multiple types of repeating units represented by formula (1).

The polymer for a water repellent according to the second embodiment of the present disclosure may also contain a repeating unit other than the repeating unit represented by formula (1).

In this case, when all repeating units are taken as 100 mol%, the proportion of repeating units represented by formula (1) may be 22 mol% or higher and 99 mol% or lower, may be 30 mol% or higher and 95 mol% or lower, or may even be 40 mol% or higher and 90 mol% or lower.

Examples of the repeating unit other than the repeating unit represented by formula (1) include a repeating unit derived from a compound having a polymerizable carbon-carbon double bond other than the repeating unit represented by formula (1).

Examples of such a repeating unit derived from a compound having a polymerizable carbon-carbon double bond include a repeating unit represented by the following formula (4): 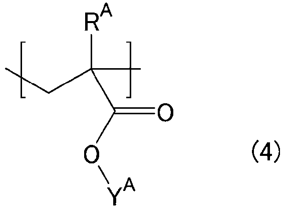 wherein R^{A} is a hydrogen atom, a fluorine atom, a chlorine atom, or a C1-C10 linear or C3-C10 branched alkyl group, some or all of the hydrogen atoms bonded to the carbon atoms in the alkyl group being optionally replaced by fluorine atoms; and
Y^{A} is a monovalent organic group.

Examples of the alkyl group exemplified as R^{A} include a methyl group, an ethyl group, and a propyl group such as a 1-propyl group or a 2-propyl group.

Examples of the monovalent organic group exemplified as Y^{A} include C1-C30 alkyl groups, C2-C30 alkenyl groups, C2-C30 alkynyl groups, C6-C30 phenyl groups, and a naphthyl group, each of which may have a linear, branched, or cyclic structure, and the hydrogen atoms of the foregoing groups may be replaced by a fluorine atom, an oxygen atom, or a nitrogen atom, and the foregoing groups may contain a hydroxy group, an ester, a lactone, a carbonyl, an ether, an amide, an amine, or a composite substituent thereof.

It should be noted that the repeating unit represented by formula (4) is preferably a repeating unit containing no fluorine atom.

Moreover, the repeating unit represented by formula (4) may be a repeating unit represented by the following formula (4a).

The polymer for a water repellent according to the second embodiment of the present disclosure containing a repeating unit represented by the following formula (4a) may have properties such as water repellency, water resistance, removal of acid-dissociable groups by an acid generated during exposure, and resultant alkali solubility. 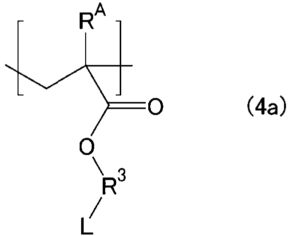 In formula (4a), R³ is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated; and L is an acid-dissociable group.

Examples of the alkylene group include saturated acyclic hydrocarbon groups, including a methylene group, an ethylene group, a propylene group such as a 1,3-propylene group or a 1,2-propylene group, a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an insalene group, a 1-methyl-1,3-propylene group, a 2-methyl-1,3-propylene group, a 2-methyl-1,2-propylene group, a 1-methyl-1,4-butylene group, a 2-methyl-1,4-butylene group, a methylidene group, an ethylidene group, a propylidene group, and a 2-propylidene group; monocyclic hydrocarbon ring groups, including C3-C10 cycloalkylene groups such as a cyclobutylene group (e.g., a 1,3-cyclobutylene group), a cyclopentylene group (e.g., a 1,3-cyclopentylene group), a cyclohexylene group (e.g., a 1,4-cyclohexylene group), and a cyclooctylene group (e.g., a 1,5-cyclooctylene group); and bridged cyclic hydrocarbon ring groups, including bi- to tetracyclic hydrocarbon ring groups such as a norbornylene group (e.g., a 1,4-norbornylene group or a 2,5-norbornylene group) and an adamantylene group (e.g., a 1,5-adamantylene group or a 2,6-adamantylene group).

Examples of the aromatic ring include an o-phenylene group, a m-phenylene group, and a p-phenylene group.

Examples of the acid-dissociable group include a tert-butyl group, a tert-amyl group, a 1,1-dimethylpropyl group, a 1-ethyl-1-methylpropyl group, a 1,1-dimethylbutyl group, an allyl group, a 1-pyrenylmethyl group, a 5-dibenzosuberyl group, a triphenylmethyl group, a 1-ethyl-1-methylbutyl group, a 1,1-diethylpropyl group, a 1,1-dimethyl-1-phenylmethyl group, a 1-methyl-1-ethyl-1-phenylmethyl group, a 1,1-diethyl-1-phenylmethyl group, a 1-methylcyclohexyl group, a 1-ethylcyclohexyl group, a 1-methylcyclopentyl group, a 1-ethylcyclopentyl group, a 1-isobornyl group, a 1-methyladamantyl group, a 1-ethyladamantyl group, a 1-isopropyladamantyl group, a 1-isopropylnorbornyl group, a 1-isopropyl-(4-methylcyclohexyl) group, a tert-butoxycarbonyl group, a tert-amyloxycarbonyl group, a methoxycarbonyl group, an ethoxycarbonyl group, an i-propoxycarbonyl group, a methoxymethyl group, an ethoxyethyl group, a butoxyethyl group, a cyclohexyloxyethyl group, a benzyloxyethyl group, a phenethyloxyethyl group, an ethoxypropyl group, a benzyloxypropyl group, a phenethyloxypropyl group, an ethoxybutyl group, an ethoxyisobutyl group, a trimethylsilyl group, an ethyldimethylsilyl group, a methyldiethylsilyl group, a triethylsilyl group, an i-propyldimethylsilyl group, a methyldi-i-propylsilyl group, a trii-propylsilyl group, a tert-butyldimethylsilyl group, a methyldi-tert-butylsilyl group, a tri-tert-butylsilyl group, a phenyldimethylsilyl group, a methyldiphenylsilyl group, a triphenylsilyl group, an acetyl group, a propionyl group, a butyryl group, a heptanoyl group, a hexanoyl group, a valeryl group, a pivaloyl group, an isovaleryl group, a lauroyl group, a myristoyl group, a palmitoyl group, a stearoyl group, an oxalyl group, a malonyl group, a succinyl group, a glutaryl group, an adipoyl group, a piperoyl group, a suberoyl group, an azelaoyl group, a sebacoyl group, a (meth)acryloyl group, a propioloyl group, a crotonoyl group, an oleoyl group, a maleoyl group, a fumaroyl group, a mesaconoyl group, a camphoroyl group, a benzoyl group, a phthaloyl group, an isophthaloyl group, a terephthaloyl group, a naphthoyl group, a toluoyl group, a hydroatropoyl group, an atropoyl group, a cinnamoyl group, a furoyl group, a thenoyl group, a nicotinoyl group, and an isonicotinoyl group.

Specifically, the repeating unit represented by formula (4) may be at least one repeating unit derived from at least one compound having a polymerizable carbon-carbon double bond selected from the group consisting of methyl methacrylate, ethyl methacrylate, n-propyl methacrylate, isopropyl methacrylate, n-butyl methacrylate, isobutyl methacrylate, t-butyl methacrylate, pentyl methacrylate, methyl acrylate, ethyl acrylate, n-propyl acrylate, isopropyl acrylate, n-butyl acrylate, isobutyl acrylate, t-butyl acrylate, pentyl acrylate, a compound represented by the following formula (4'-1), a compound represented by the following formula (4'-2), a compound represented by the following formula (4'-3), a compound represented by the following formula (4'-4), a compound represented by the following formula (4'-5), a compound represented by the following formula (4'-6), a compound represented by the following formula (4'-7), a compound represented by the following formula (4'-8), a compound represented by the following formula (4'-9), a compound represented by the following formula (4'-10), a compound represented by the following formula (4'-11), a compound represented by the following formula (4'-12), a compound represented by the following formula (4'-13), a compound represented by the following formula (4'-14), a compound represented by the following formula (4'-15), and a compound represented by the following formula (4'-16):

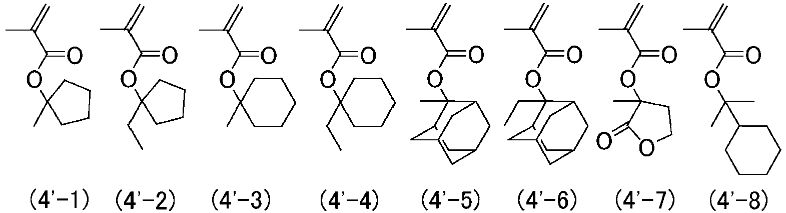

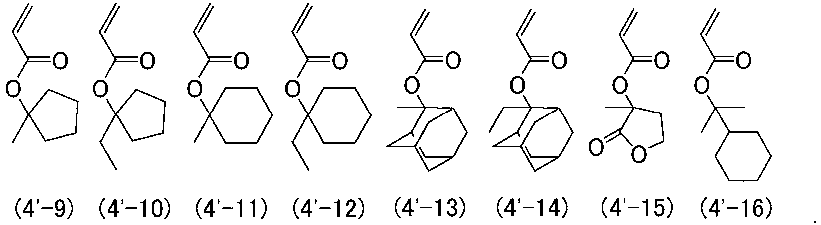

Specific preferred examples of the repeating unit represented by formula (4) include repeating units represented by the following chemical formulae:

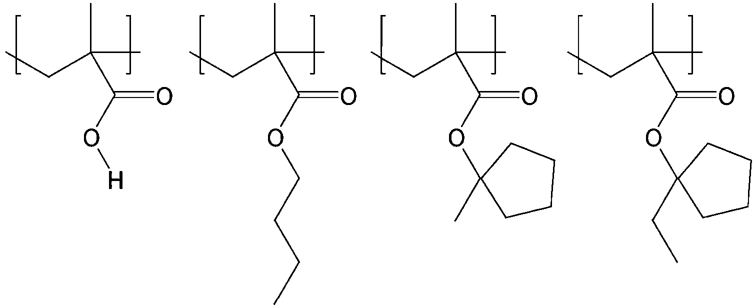

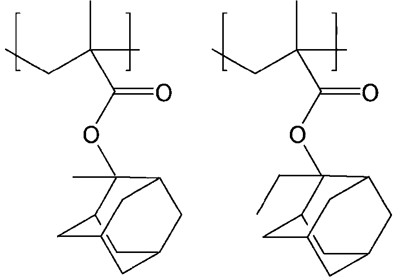

Moreover, the repeating unit derived from a compound having a polymerizable carbon-carbon double bond may contain a repeating unit represented by the following formula (5).

The polymer for a water repellent according to the second embodiment of the present disclosure containing a repeating unit represented by formula (5) may have properties such as alkali solubility.

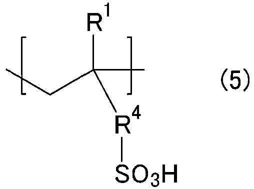

In formula (5), R⁴ is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated.

Examples of the alkylene group exemplified as R⁴ include saturated acyclic hydrocarbon groups, including a methylene group, an ethylene group, a propylene group such as a 1,3-propylene group or a 1,2-propylene group, a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an insalene group, a 1-methyl-1,3-propylene group, a 2-methyl-1,3-propylene group, a 2-methyl-1,2-propylene group, a 1-methyl-1,4-butylene group, a 2-methyl-1,4-butylene group, a methylidene group, an ethylidene group, a propylidene group, and a 2-propylidene group; monocyclic hydrocarbon ring groups, including C3-C10 cycloalkylene groups such as a cyclobutylene group (e.g., a 1,3-cyclobutylene group), a cyclopentylene group (e.g., a 1,3-cyclopentylene group), a cyclohexylene group (e.g., a 1,4-cyclohexylene group), and a cyclooctylene group (e.g., a 1,5-cyclooctylene group); and bridged cyclic hydrocarbon ring groups, including bi- to tetracyclic hydrocarbon ring groups such as a norbornylene group (e.g., a 1,4-norbornylene group or a 2,5-norbornylene group) and an adamantylene group (e.g., a 1,5-adamantylene group or a 2,6-adamantylene group).

Examples of the aromatic ring exemplified as R⁴ include an o-phenylene group, a m-phenylene group, and a p-phenylene group.

Moreover, the repeating unit derived from a compound having a polymerizable carbon-carbon double bond may contain an acid-decomposable group.

When such a polymer for a water repellent is used to form a resin film on a substrate, exposing the resin film to electromagnetic waves or high-energy rays (such as electron beams) having a wavelength of 300 nm or less causes the acid-decomposable group to decompose, generating an acid in the resin film. This acid can improve the solubility of the exposed portion of the resin film in an alkaline developer during development.

In the polymer for a water repellent according to the second embodiment of the present disclosure containing multiple types of repeating units represented by formula (1), R¹ in each repeating unit may be the same or different. The same applies to R² and X.

In the polymer for a water repellent according to the second embodiment of the present disclosure containing multiple types of repeating units represented by formula (4), R^{A} in each repeating unit may be the same or different. The same applies to Y^{A}.

In the polymer for a water repellent according to the second embodiment of the present disclosure containing multiple types of repeating units represented by formula (4a), R^{A} in each repeating unit may be the same or different. The same applies to R³ and L.

In the polymer for a water repellent according to the second embodiment of the present disclosure containing multiple types of repeating units represented by formula (5), R⁴ in each repeating unit may be the same or different.

Also, in the polymer for a water repellent according to the second embodiment of the present disclosure containing at least two repeating units selected from repeating units represented by formula (1) and repeating units represented by formula (2), R¹ in each repeating unit may be the same or different.

The weight average molecular weight of the polymer for a water repellent according to the second embodiment of the present disclosure may be 5000 to 20000 or may even be 7000 to 12000. Herein, the weight average molecular weight of the polymer means the numerical value measured by gel permeation chromatography (GPC) under the following conditions.

### [GPC Conditions]

Apparatus: HLC-8320GPC manufactured by Tosoh Corporation
Columns for polymerizable monomer analysis: TSKgel series manufactured by Tosoh Corporation (G2500HXL, G2000HXL, G1000HXL, and G1000HXL connected in series in that order)
Columns for polymer analysis: TSKgel series manufactured by Tosoh Corporation (G2500HXL, G2000HXL, G1000HXL, and G1000HXL connected in series in that order)
Temperature program: 40°C (retention)
Flow rate: 1 mL/min
Detector: differential refractometer (RI)
Eluent: tetrahydrofuran (THF)
Reference materials: polystyrene standard solutions

Next, an exemplary method for producing the polymer for a water repellent according to the second embodiment of the present disclosure is described.

The method for producing the polymer for a water repellent according to the second embodiment of the present disclosure includes a step of providing a fluorine-containing polymerizable monomer and a polymerization step.

### <Step of Providing Fluorine-Containing Polymerizable Monomer>

In the method for producing the polymer for a water repellent according to the second embodiment of the present disclosure, first, a compound represented by the following formula (6) is provided.

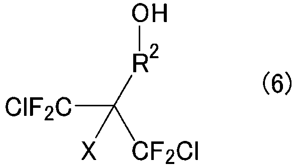

In formula (6), R² is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated; and
X is a hydroxy group, an alkoxy group, or a hydrogen atom.

Subsequently, the compound represented by formula (6) is reacted with at least one selected from the group consisting of an acid halide, an acid anhydride, an ester, and a carboxylic acid.

Examples of the acid halide include methacryloyl chloride, methacryloyl bromide, methacryloyl fluoride, acryloyl chloride, acryloyl bromide, and acryloyl fluoride. Examples of the acid anhydride include methacrylic anhydride and acrylic anhydride. Examples of the ester include methyl methacrylate, ethyl methacrylate, methyl acrylate, butyl acrylate, n-propyl acrylate, iso-propyl acrylate, n-butyl acrylate, iso-butyl acrylate, sec-butyl acrylate, tert-butyl acrylate, n-propyl methacrylate, iso-propyl methacrylate, n-butyl methacrylate, iso-butyl methacrylate, sec-butyl methacrylate, and tert-butyl methacrylate. Examples of the carboxylic acid include methacrylic acid and acrylic acid.

The reaction between the compound represented by formula (6) and any of these compounds may be performed with the addition of an acid or a base, as necessary. Also, the reaction conditions are preferably 0°C to 130°C for 0.5 to 10 hours.

The separation and purification of the product after the reaction may be carried out by a conventional method. For example, concentration, distillation, extraction, recrystallization, filtration, column chromatography, and other methods can be used, and two or more methods may be used in combination.

A fluorine-containing polymerizable monomer represented by the following formula (7) can be produced through the above steps. The fluorine-containing polymerizable monomer represented by formula (7) is a compound corresponding to the repeating unit represented by formula (1) in the polymer for a water repellent according to the second embodiment of the present disclosure.

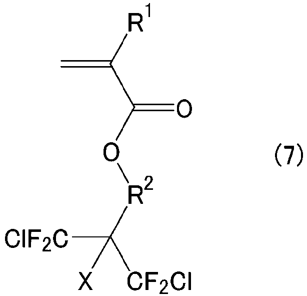

In formula (7), R¹ is a hydrogen atom, a fluorine atom, a chlorine atom, or a C1-C10 linear or C3-C10 branched alkyl group, some or all of the hydrogen atoms bonded to the carbon atoms in the alkyl group being optionally replaced by fluorine atoms;
R² is a single bond, an alkylene group optionally having a linear, branched, or cyclic structure, an aromatic ring, an ester, a carbonyl, an ether, an amide, an amine, or a composite substituent thereof, a part of which is optionally fluorinated and/or chlorinated; and
X is a hydroxy group, an alkoxy group, or a hydrogen atom.

### <Polymerization Step>

Next, the fluorine-containing polymerizable monomer represented by formula (7) is polymerized.

Here, the polymerization may be carried out together with a monomer other than the fluorine-containing polymerizable monomer represented by formula (7).

The reaction during the polymerization is not limited and may be a radical polymerization reaction, an ionic polymerization reaction, a coordination anionic polymerization reaction, a living anionic polymerization reaction, or a cationic polymerization reaction. A radical polymerization reaction is preferred among these.

When the polymerization reaction is a radical polymerization reaction, any polymerization initiator that can cause a polymerization reaction can be used, such as an azo compound, a peroxide compound, or a redox compound.

Examples of the azo compound include azobisisobutyronitrile. Examples of the peroxide compound include t-butyl peroxypivalate, di-t-butyl peroxide, i-butyryl peroxide, lauroyl peroxide, succinic acid peroxide, dicinnamyl peroxide, di-n-propyl peroxydicarbonate, t-butyl peroxyallyl monocarbonate, benzoyl peroxide, hydrogen peroxide, and ammonium persulfate.

Examples of the redox compound include combinations of oxidizing agents and reducing agents, in which the oxidizing agents include hydrogen peroxide, persulfates, cumene hydroperoxide, etc., while the reducing agents include iron(II) ion salts, copper(I) ion salts, ammonia, triethylamine, etc.

In the radical polymerization reaction, a polymerization solvent may also be used.

Any polymerization solvent that does not inhibit the radical polymerization reaction can be used, and it may be either an organic solvent or water. Examples of the organic solvent include hydrocarbon solvents, ester solvents, ketone solvents, alcohol solvents, ether solvents, cyclic ether solvents, fluorocarbon solvents, and aromatic solvents. Only one of these solvents may be used, or two or more thereof may be used in combination.

Examples of the ester solvents include acetic acid and n-butyl acetate.

Examples of the ketone solvents include acetone and methyl isobutyl ketone.

Examples of the hydrocarbon solvents include toluene and cyclohexane.

Examples of the alcohol solvents include methanol, isopropyl alcohol, and ethylene glycol monomethyl ether.

In the radical polymerization reaction, a molecular weight modifier such as mercaptan may also be used.

Although the reaction temperature in the radical polymerization reaction may be varied as appropriate depending on the radical polymerization initiator or the type of radical polymerization initiator, it is preferably 20°C or higher and 200°C or lower, more preferably 30°C or higher and 140°C or lower.

Following the polymerization step, a known method can be used to remove the medium, either organic solvent or water, from the solution or dispersion containing the synthesized polymer. Specific examples of such methods include reprecipitation, filtration, and heating distillation under reduced pressure.

The polymer for a water repellent according to the second embodiment of the present disclosure can be produced through the above steps.

### (Third Embodiment)

Next, a composition for forming a water-repellent film according to a third embodiment of the present disclosure is described.

The composition for forming a water-repellent film according to the third embodiment of the present disclosure contains the copolymer according to the first embodiment or the polymer for a water repellent according to the second embodiment.

The composition for forming a water-repellent film according to the third embodiment of the present disclosure may contain two or more types of copolymers according to the first embodiment or polymers for a water repellent according to the second embodiment.

The composition for forming a water-repellent film according to the third embodiment of the present disclosure can be used to form a resin film with water repellency (water-repellent film).

For example, a coating film may be formed by adding other components such as a solvent to the composition for forming a water-repellent film according to the third embodiment of the present disclosure, and applying the resulting composition for forming a water-repellent film to a substrate, followed by curing and drying.

It should be noted that the resin film including a coating film of the composition for forming a water-repellent film according to the third embodiment of the present disclosure also corresponds to a resin film according to the present disclosure.

The composition for forming a water-repellent film according to the third embodiment of the present disclosure can be used as a component of a non-topcoat resist film or an upper layer film for protecting a resist film.

Moreover, a water repellent film formed from the composition for forming a water-repellent film according to the third embodiment of the present disclosure can be used not only in the above-described applications but also in plastics, residential waterproofing materials, water-repellent coatings for electronic devices such as smartphones, partitions for biosensors, microfluidic channels, automotive glass, etc.

The following describes in detail the use of the composition for forming a water-repellent film according to the third embodiment of the present disclosure as a component of a non-topcoat resist film or an upper layer film for protecting a resist film.

When the composition for forming a water-repellent film according to the third embodiment of the present disclosure is used to form a non-topcoat resist film, the composition for forming a water-repellent film according to the third embodiment of the present disclosure may contain an acid generator and a solvent.

When the composition for forming a water-repellent film according to the third embodiment of the present disclosure is used to form an upper layer film, the composition for forming a water-repellent film according to the third embodiment of the present disclosure may contain a solvent.

The non-topcoat resist film formed from the composition for forming a water-repellent film according to the third embodiment of the present disclosure may be either of a negative type or a positive type.

Non-limiting examples of the substrate on which the non-topcoat resist film is formed include a silicon substrate, a germanium substrate, a silicon carbide (SiC) substrate, a gallium nitride (GaN) substrate, a compound semiconductor substrate, and an insulating substrate. The substrate may be one on which an antireflection film has been formed.

Moreover, when forming an upper layer film, the composition for forming a water-repellent film according to the third embodiment of the present disclosure may be applied onto a resist film (lower layer film).

When the composition for forming a water-repellent film according to the third embodiment of the present disclosure is used to form a non-topcoat resist film, the non-topcoat resist film may be formed by applying the composition for forming a water-repellent film according to the third embodiment of the present disclosure to a substrate. Thereafter, the non-topcoat resist film may be subjected to exposure or liquid immersion lithography.

Also, when the composition for forming a water-repellent film according to the third embodiment of the present disclosure is used to form an upper layer film, the upper layer film may be formed by applying the composition for forming a water-repellent film according to the third embodiment of the present disclosure onto a resist film. Thereafter, the upper layer film may be subjected to exposure or liquid immersion lithography.

It should be noted that the resin film including a coating film of the composition for forming a water-repellent film according to the third embodiment of the present disclosure has a low hysteresis with respect to an immersion fluid and a low sliding angle in liquid immersion lithography, and is therefore preferably used in liquid immersion lithography.

### <<Composition for Forming Water-Repellent Film to Form Non-Topcoat Resist Film>>

As described above, when the composition for forming a water-repellent film according to the third embodiment of the present disclosure is used to form a non-topcoat resist film, the composition for forming a water-repellent film according to the third embodiment of the present disclosure may contain an acid generator and a solvent in addition to the copolymer according to the first embodiment or the polymer for a water repellent according to the second embodiment.

Examples of the acid generator include onium salt acid generators such as iodonium salts and sulfonium salts, oxime sulfonate acid generators, diazomethane acid generators such as bisalkyl- or bisaryl-sulfonyl diazomethanes and poly(bissulfonyl) diazomethanes, nitrobenzyl sulfonate acid generators, iminosulfonate acid generators, and disulfone acid generators.

Specific examples of the onium salt acid generators include diphenyliodonium trifluoromethanesulfonate or nonafluorobutanesulfonate, bis(4-tert-butylphenyl)iodonium trifluoromethanesulfonate or nonafluorobutanesulfonate, triphenylsulfonium trifluoromethanesulfonate and the corresponding heptafluoropropanesulfonate or nonafluorobutanesulfonate, tri(4-methylphenyl)sulfonium trifluoromethanesulfonate and the corresponding heptafluoropropanesulfonate or nonafluorobutanesulfonate, dimethyl(4-hydroxynaphthyl)sulfonium trifluoromethanesulfonate and the corresponding heptafluoropropanesulfonate or nonafluorobutanesulfonate, monophenyldimethylsulfonium trifluoromethanesulfonate and the corresponding heptafluoropropanesulfonate or nonafluorobutanesulfonate, diphenylmonomethylsulfonium trifluoromethanesulfonate and the corresponding heptafluoropropanesulfonate or nonafluorobutanesulfonate, (4-methylphenyl)diphenylsulfonium trifluoromethanesulfonate and the corresponding heptafluoropropanesulfonate or nonafluorobutanesulfonate, (4-methoxyphenyl)diphenylsulfonium trifluoromethanesulfonate and the corresponding heptafluoropropanesulfonate or nonafluorobutanesulfonate, tri(4-tert-butyl)phenylsulfonium trifluoromethanesulfonate and the corresponding heptafluoropropanesulfonate or nonafluorobutanesulfonate, diphenyl(1-(4-methoxy)naphthyl)sulfonium trifluoromethanesulfonate and the corresponding heptafluoropropanesulfonate or nonafluorobutanesulfonate, and di(1-naphthyl)phenylsulfonium trifluoromethanesulfonate and the corresponding heptafluoropropanesulfonate or nonafluorobutanesulfonate. In addition, the foregoing onium salts in which the anionic part of the onium salts has been replaced with methanesulfonate, n-propanesulfonate, n-butanesulfonate, or n-octanesulfonate can also be used.

Specific examples of the oxime sulfonate acid generators include α-(p-toluenesulfonyloxyimino)-benzyl cyanide, α-(p-chlorobenzenesulfonyloxyimino)-benzyl cyanide, α-(4-nitrobenzenesulfonyloxyimino)-benzyl cyanide, α-(4-nitro-2-trifluoromethylbenzenesulfonyloxyimino)-benzyl cyanide, α-(benzenesulfonyloxyimino)-4-chlorobenzyl cyanide, α-(benzenesulfonyloxyimino)-2,4-dichlorobenzyl cyanide, α-(benzenesulfonyloxyimino)-2,6-dichlorobenzyl cyanide, α-(benzenesulfonyloxyimino)-4-methoxybenzyl cyanide, α-(2-chlorobenzenesulfonyloxyimino)-4-methoxybenzyl cyanide, α-(benzenesulfonyloxyimino)-thien-2-ylacetonitrile, α-(4-dodecylbenzenesulfonyloxyimino)-benzyl cyanide, α-[(p-toluenesulfonyloxyimino)-4-methoxyphenyllacetonitrile, α-[(dodecylbenzenesulfonyloxyimino)-4-methoxyphenyllacetonitrile, α-(tosyloxyimino)-4-thienyl cyanide, α-(methylsulfonyloxyimino)-1-cyclopentenylacetonitrile, α-(methylsulfonyloxyimino)-1-cyclohexenylacetonitrile, α-(methylsulfonyloxyimino)-1-cycloheptenylacetonitrile, α-(methylsulfonyloxyimino)-1-cyclooctenylacetonitrile, α-(trifluoromethylsulfonyloxyimino)-1-cyclopentenylacetonitrile, α-(trifluoromethylsulfonyloxyimino)-cyclohexylacetonitrile, α-(ethylsulfonyloxyimino)-ethylacetonitrile, α-(propylsulfonyloxyimino)-propylacetonitrile, α-(cyclohexylsulfonyloxyimino)-cyclopentylacetonitrile, α-(cyclohexylsulfonyloxyimino)-cyclohexylacetonitrile, α-(cyclohexylsulfonyloxyimino)-1-cyclopentenylacetonitrile, α-(ethylsulfonyloxyimino)-1-cyclopentenylacetonitrile, α-(isopropylsulfonyloxyimino)-1-cyclopentenylacetonitrile, α-(n-butylsulfonyloxyimino)-1-cyclopentenylacetonitrile, α-(ethylsulfonyloxyimino)-1-cyclohexenylacetonitrile, α-(isopropylsulfonyloxyimino)-1-cyclohexenylacetonitrile, α-(n-butylsulfonyloxyimino)-1-cyclohexenylacetonitrile, α-(methylsulfonyloxyimino)-phenylacetonitrile, α-(methylsulfonyloxyimino)-p-methoxyphenylacetonitrile, α-(trifluoromethylsulfonyloxyimino)-phenylacetonitrile, α-(trifluoromethylsulfonyloxyimino)-p-methoxyphenylacetonitrile, α-(ethylsulfonyloxyimino)-p-methoxyphenylacetonitrile, α-(propylsulfonyloxyimino)-p-methylphenylacetonitrile, and α-(methylsulfonyloxyimino)-p-bromophenylacetonitrile.

As for the diazomethane acid generators such as bisalkyl- or bisaryl-sulfonyl diazomethanes and poly(bissulfonyl) diazomethanes, specific examples of the bisalkyl- or bisaryl-sulfonyl diazomethanes include bis(isopropylsulfonyl)diazomethane, bis(p-toluenesulfonyl)diazomethane, bis(1,1-dimethylethylsulfonyl)diazomethane, bis(cyclohexylsulfonyl)diazomethane, and bis(2,4-dimethylphenylsulfonyl)diazomethane.

Examples of the solvent include methanol, ethanol, 1-propanol, isopropanol, n-propanol, 1-butanol, 2-butanol, 2-methyl-2-propanol, 1-pentanol, 2-pentanol, 3-pentanol, n-hexanol, cyclohexanol, 2-methyl-2-butanol, 3-methyl-2-butanol, 2-methyl-1-butanol, 3-methyl-1-butanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, ethylene glycol, propylene glycol, tetrahydrofuran, dioxane, ethylene glycol monomethyl ether, ethylene glycol monoethyl ether, ethylene glycol dimethyl ether, ethylene glycol diethyl ether, diethylene glycol monomethyl ether, diethylene glycol monoethyl ether, diethylene glycol dimethyl ether, diethylene glycol diethyl ether, diethylene glycol ethyl methyl ether, propylene glycol monomethyl ether, propylene glycol monoethyl ether, ethylene glycol ethyl ether acetate, diethylene glycol ethyl ether acetate, propylene glycol ethyl ether acetate, propylene glycol monomethyl ether acetate, toluene, xylene, acetone, methyl ethyl ketone, methyl isobutyl ketone, cyclohexanone, 4-hydroxy-4-methyl-2-pentanone, diacetone alcohol, ethyl acetate, butyl acetate, ethyl 2-hydroxypropionate, ethyl 2-hydroxy-2-methylpropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, and water.

It should be noted that when the composition for forming a water-repellent film according to the third embodiment of the present disclosure is used to form a non-topcoat resist film, the composition for forming a water-repellent film according to the third embodiment of the present disclosure may contain a basic compound.

Examples of the basic compound include monoalkylamines such as n-hexylamine, n-heptylamine, n-octylamine, n-nonylamine, and n-decylamine; dialkylamines such as diethylamine, di-n-propylamine, di-n-heptylamine, di-n-octylamine, and dicyclohexylamine; trialkylamines such as trimethylamine, triethylamine, tri-n-propylamine, tri-n-butylamine, tri-n-hexylamine, tri-n-pentylamine, tri-n-heptylamine, tri-n-octylamine, tri-n-nonylamine, tri-n-decanylamine, and tri-n-dodecylamine; alkyl alcohol amines such as diethanolamine, triethanolamine, diisopropanolamine, triisopropanolamine, di-n-octanolamine, and tri-n-octanolamine; and piperidine, piperazine, 1,5-diazabicyclo[4.3.0]-5-nonene, 1,8-diazabicyclo[5.4.0]-7-undecene, hexamethylenetetramine, and 1,4-diazabicyclo[2.2.2]octane.

Further, when the composition for forming a water-repellent film according to the third embodiment of the present disclosure is used to form a non-topcoat resist film, the composition for forming a water-repellent film according to the third embodiment of the present disclosure may contain a base resin other than the copolymer according to the first embodiment or the polymer for a water repellent according to the second embodiment, or a weak-acid photoacid generator (weak-acid PAG).

Examples of the base resin include resins containing the structures represented by the following chemical formulae: 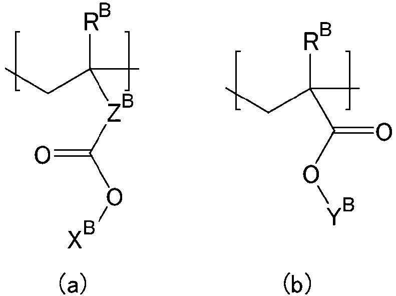 wherein R^{B} is a hydrogen atom, a fluorine atom, a methyl group, or a trifluoromethyl group; Z^{B} is a single bond, a phenylene group, a naphthylene group, or (main chain)-C(=O)-O-Z'-, where Z' is a C1-C10 alkanediyl group optionally containing a hydroxy group, an ether bond, an ester bond, or a lactone ring, or a phenylene group or a naphthylene group; X^{B} is an acid-labile group; and Y^{B} is a hydrogen atom, or a polar group containing at least one structure selected from a hydroxy group, a cyano group, a carbonyl group, a carboxyl group, an ether bond, an ester bond, a sulfonic acid ester bond, a carbonate bond, a lactone ring, a sultone ring, and carboxylic anhydride (-C(=O)-O-C(=O)-).

The alkanediyl group may be linear, branched, or cyclic, and specific examples include a methylene group, an ethane-1,1-diyl group, an ethane-1,2-diyl group, a propane-1,2-diyl group, a propane-2,2-diyl group, a propane-1,3-diyl group, a 2-methylpropane-1,3-diyl group, a butane-1,3-diyl group, a butane-2,3-diyl group, a butane-1,4-diyl group, a pentane-1,3-diyl group, a pentane-1,4-diyl group, a 2,2-dimethylpropane-1,3-diyl group, a pentane-1,5-diyl group, a hexane-1,6-diyl group, a cyclopentane-1,2-diyl group, a cyclopentane-1,3-diyl group, and a cyclohexane-1,6-diyl group.

Examples of structures in which Z^{B} in formula (a) is changed include those shown below, but are not limited thereto. It should be noted that, in the following formulae, R^{B} and X^{B} are the same as described above.

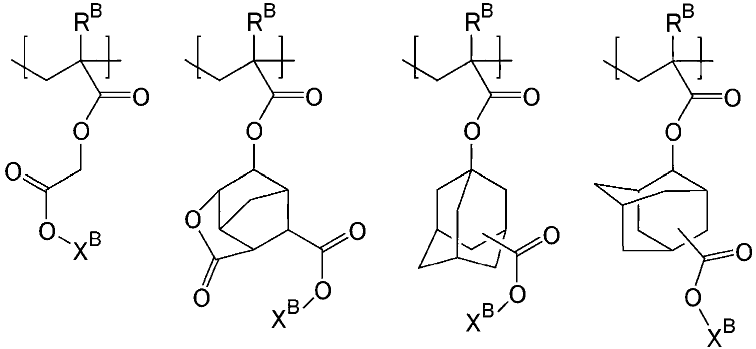

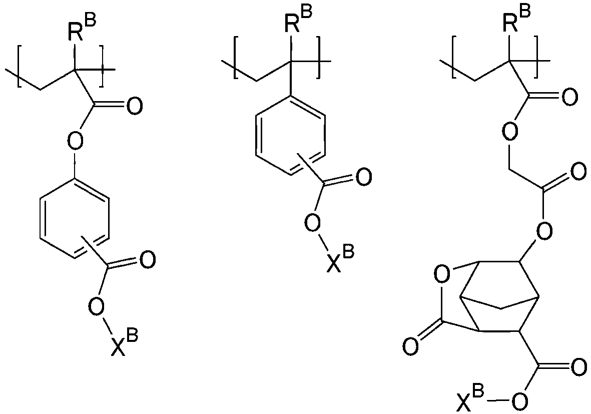

The acid-labile group represented by X^{B} is not limited, and examples include C4-C20 tertiary alkyl groups, trialkylsilyl groups in which each alkyl group is a C1-C6 alkyl group, and C4-C20 oxoalkyl groups.

In particular, the acid-labile group is preferably any of those represented by the following formulae (xa), (xb), and (xc): 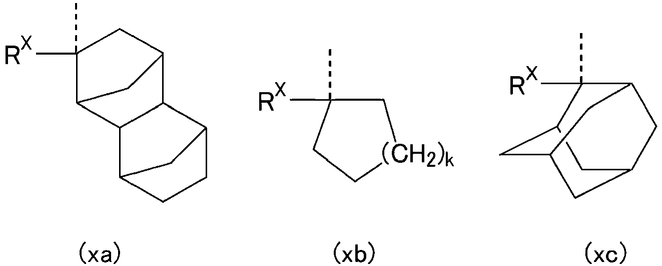 wherein R^{X} is a C1-C10 monovalent hydrocarbon group optionally containing a heteroatom; k is 1 or 2; and the dashed line is a bond.

In the case where the tertiary alicyclic hydrocarbon group represented by formula (xa), (xb), or (xc) is bonded to the ester oxygen, it provides higher acid-decomposability due to steric repulsion than other tertiary alkyl groups, such as a tert-butyl group or a tert-pentyl group.

Examples of the repeating unit represented by formula (a) include those shown below, but are not limited thereto. It should be noted that, in the following formulae, R^{B} is a hydrogen atom, a fluorine atom, a methyl group, or a trifluoromethyl group.

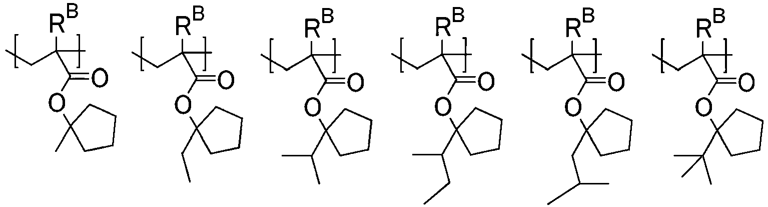

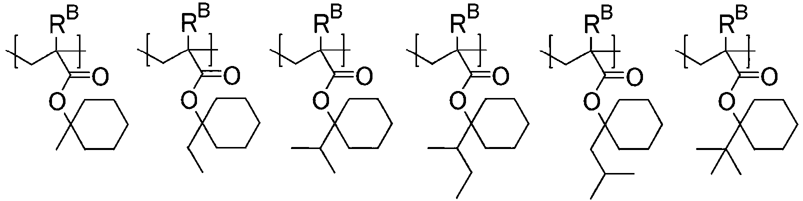

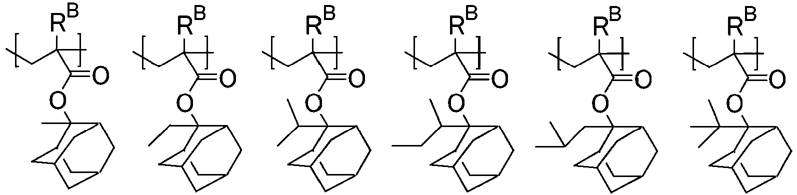

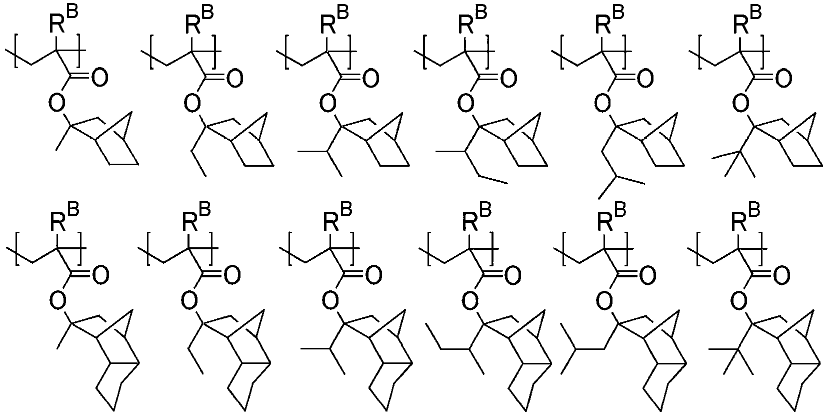

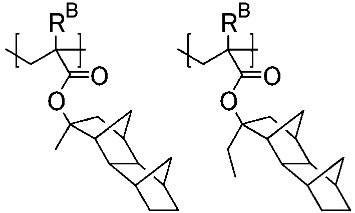

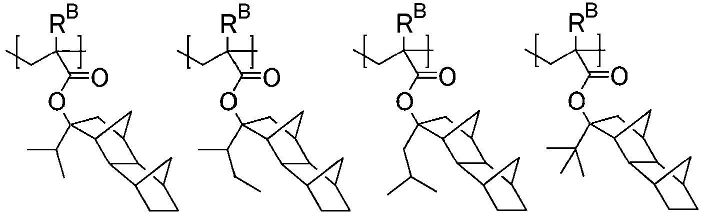

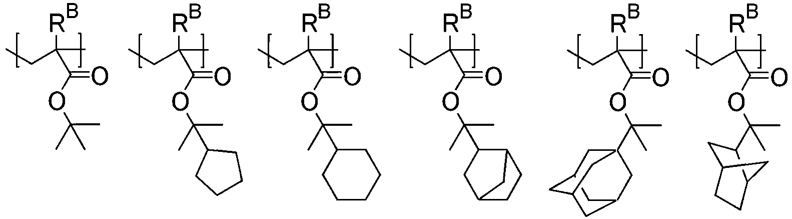

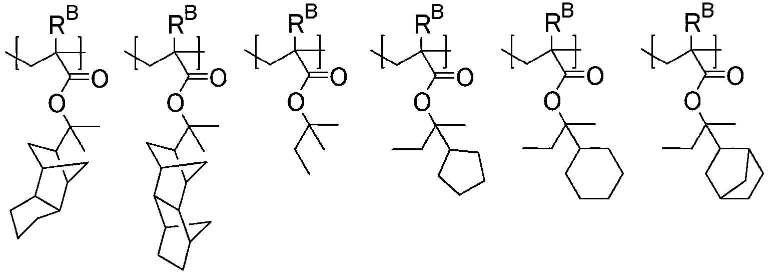

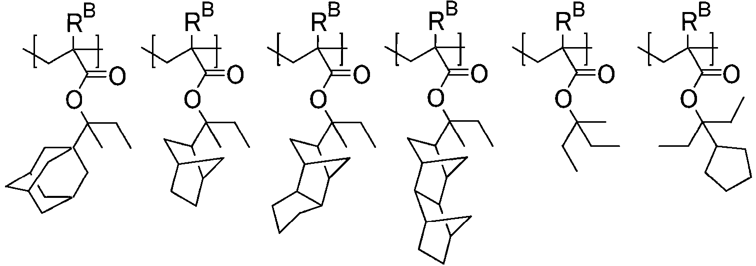

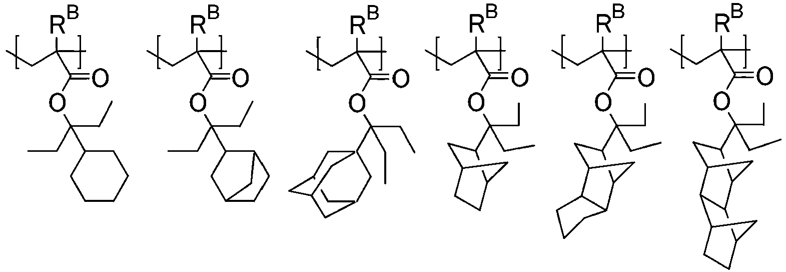

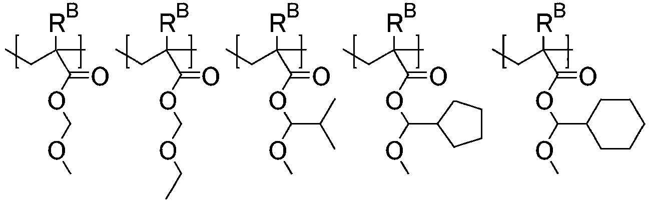

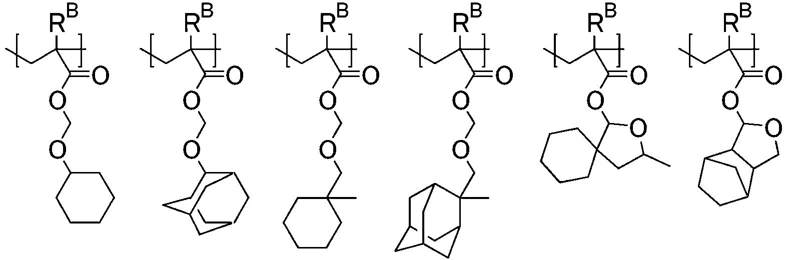

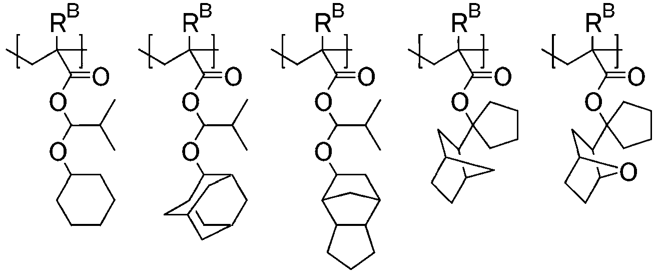

It should be noted that the above specific examples apply to the case where Z^{B} is a single bond, but the same acid-labile groups can also be combined with Z^{B} other than a single bond.

Examples of the repeating unit represented by formula (b) include those shown below, but are not limited thereto. It should be noted that, in the following formulae, R^{B} is a hydrogen atom, a fluorine atom, a methyl group, or a trifluoromethyl group.

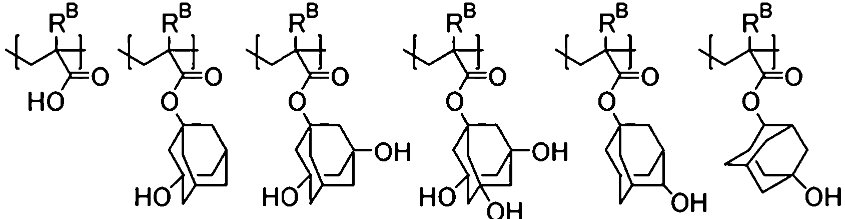

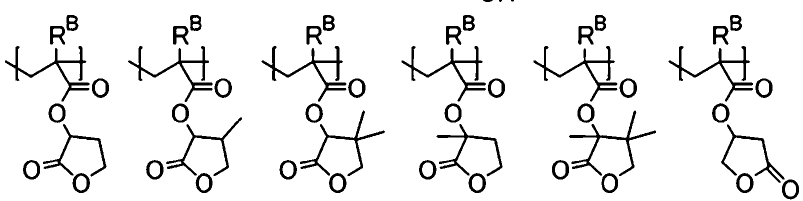

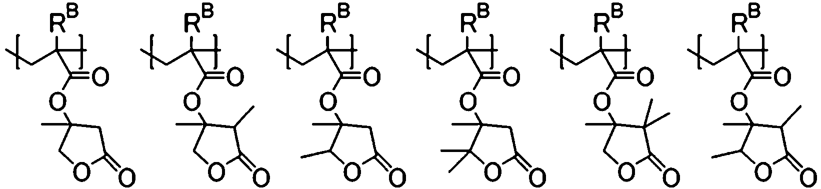

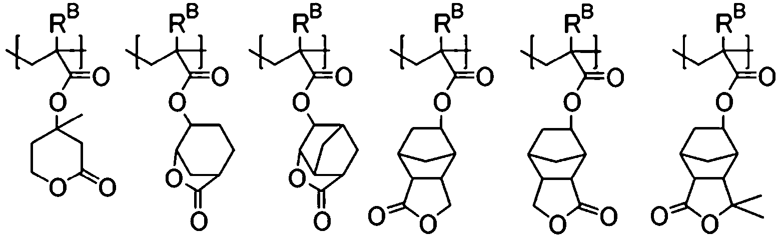

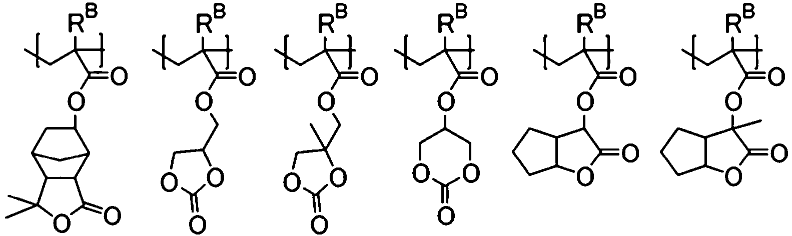

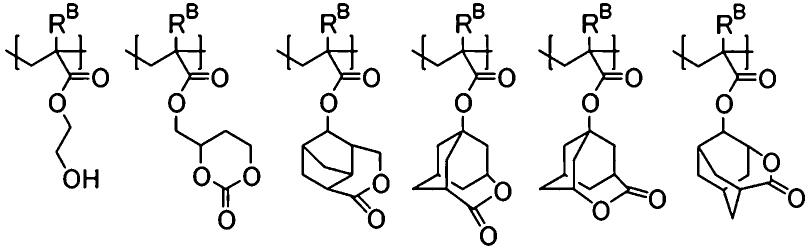

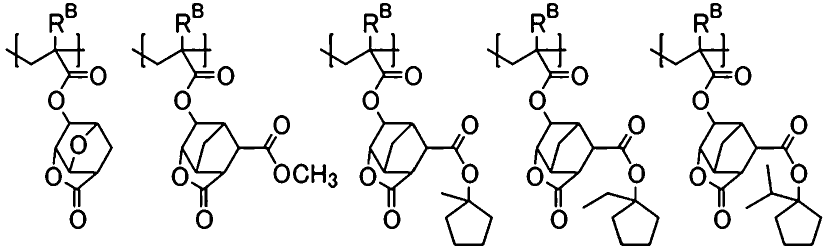

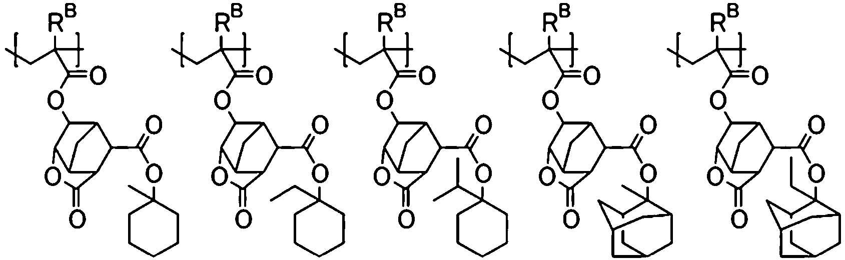

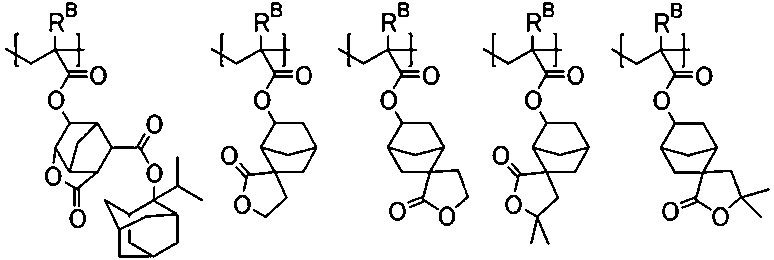

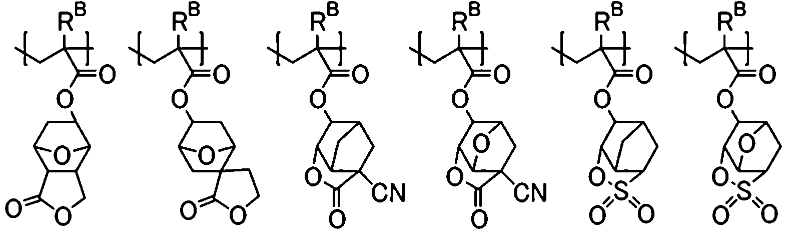

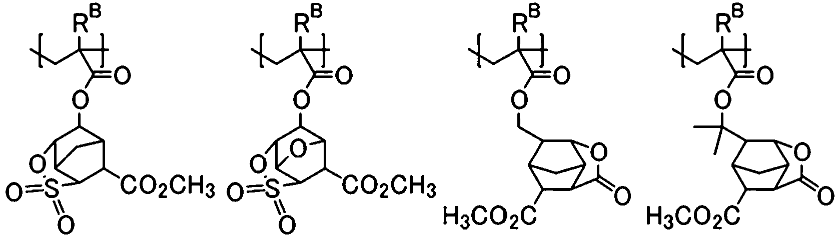

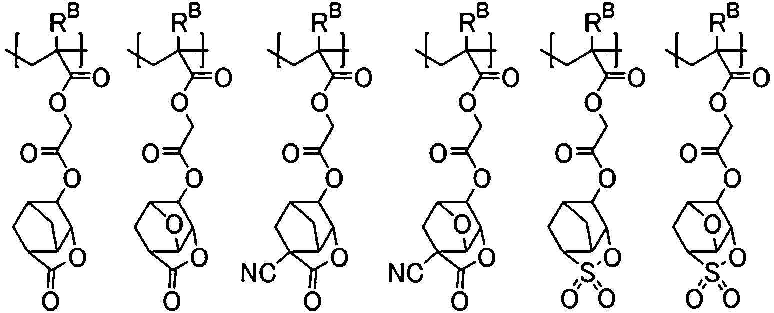

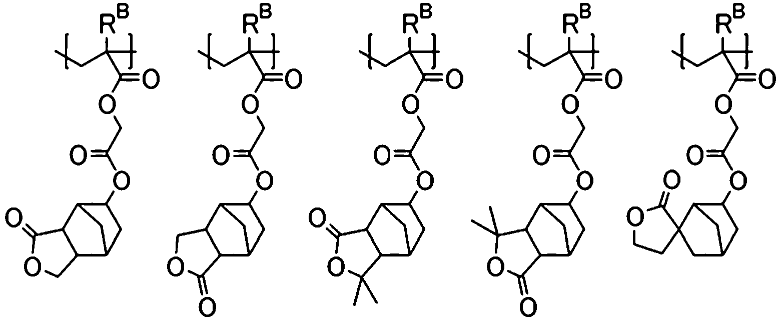

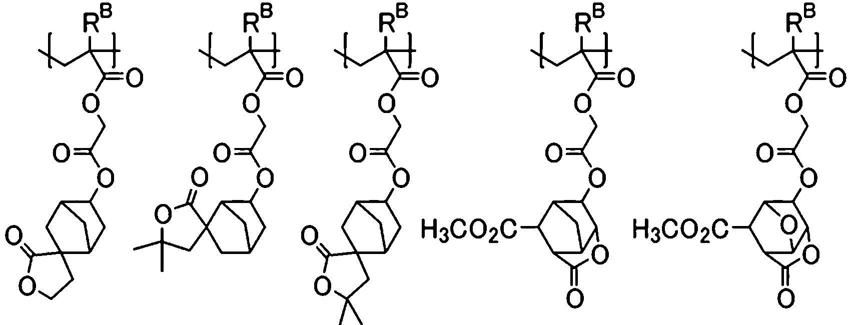

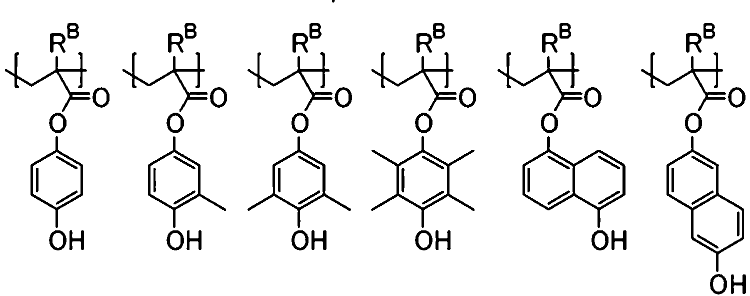

The base resin in the composition for forming a water-repellent film according to the third embodiment of the present disclosure may contain one or two or more of the above structures.

In the case where the base resin contains two or more of the above structures, R^{B}, X^{B}, Y^{B}, Z^{B}, and R^{X} in each structure may be the same or different.

The weak-acid PAG used may be a photodegradable base that can be exposed to generate a weak acid.

Examples of the photodegradable base include onium salt compounds that can be decomposed by exposure. Examples of the onium salt compounds include a sulfonium salt compound represented by the following formula (9-1) and an iodonium salt compound represented by the following formula (9-2): 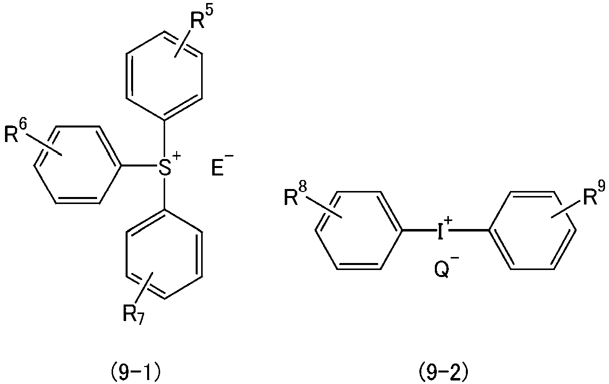
wherein R⁵ to R⁹ are each independently a hydrogen atom, an alkyl group, an alkoxy group, a hydroxy group, or a halogen atom; and
   E⁻ and Q⁻ are each independently OH⁻, R^{β}-COO⁻, R^{β}-SO₃⁻, or an anion represented by the following formula (9-3), provided that R^{β} is an alkyl group, an aryl group, or an aralkyl group, 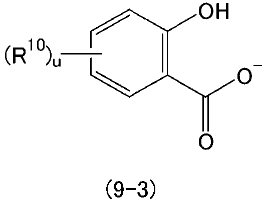
wherein R¹⁰ is a C1-C12 linear or branched alkyl group in which some or all of the hydrogen atoms are optionally replaced by fluorine atoms, or a C1-C12 linear or branched alkoxyl group; and u is an integer of 0 to 2.

Specific examples of the weak-acid PAG include the following compounds.

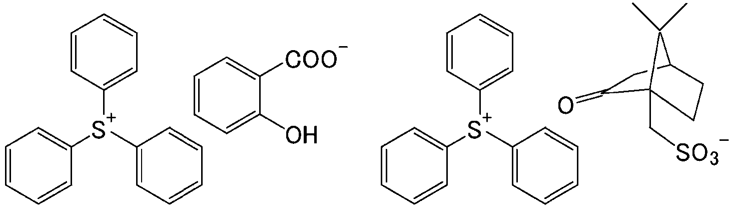

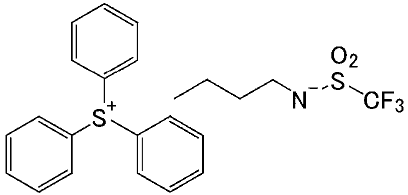

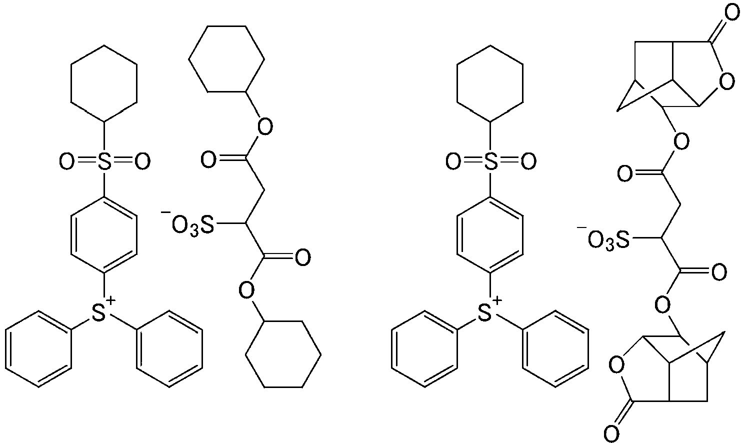

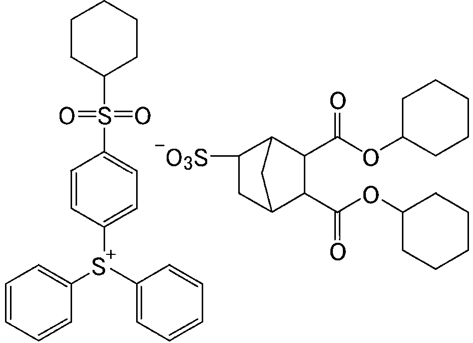

The non-topcoat resist film can be formed through: a step of providing a composition for forming a water-repellent film, a film formation step including applying the composition for forming a water-repellent film to a substrate to form a film, an exposure step including exposing the film to electromagnetic waves or high-energy rays having a wavelength of 300 nm or less through a photomask to transfer the pattern of the photomask to the film, and a development step including developing the film using a developer to obtain the pattern, as described in detail later.

### ≪Composition for Forming Water-Repellent Film to Form Upper Layer Film>>

As described above, when the composition for forming a water-repellent film according to the third embodiment of the present disclosure is used to form an upper layer film, the composition for forming a water-repellent film according to the third embodiment of the present disclosure preferably contains a solvent in addition to the copolymer according to the first embodiment or the polymer for a water repellent according to the second embodiment.

Examples of the solvent include the same solvents as those described above for forming the non-topcoat resist film.

The upper layer film may be formed by a method that includes a step of providing a composition for forming a water-repellent film, a film formation step including applying the composition for forming a water-repellent film onto a resist film to form an upper layer film, an exposure step including exposing the upper layer film and the resist film to electromagnetic waves or high-energy rays having a wavelength of 300 nm or less through a photomask to transfer the pattern of the photomask to the resist film, and a development step including removing the upper layer film and developing the resist film using a developer to obtain the pattern, as described in detail later.

### (Fourth Embodiment)

Next, a method for forming a resist pattern according to a fourth embodiment of the present disclosure is described.

The method for forming a resist pattern according to the fourth embodiment of the present disclosure includes: a film formation step including applying the composition for forming a water-repellent film according to the third embodiment of the present disclosure to a surface of a substrate or a lower layer film to form a resin film; and a liquid immersion lithography step including exposing the resin film with a surface in direct contact with water to electromagnetic waves or high-energy rays having a wavelength of 300 nm or less through the water.

It should be noted that, in the method for forming a resist pattern according to the fourth embodiment of the present disclosure, the liquid immersion lithography step may be followed by a development step including removal of the waste material and development using a developer.

Liquid immersion lithography refers to an exposure process performed with an immersion fluid that fills the space between the lens of an exposure apparatus and a substrate.

When the space between the lens of an exposure apparatus and a substrate is filled with an immersion fluid, the incident angle of the exposure light entering the substrate through the lens can be reduced compared to when the space between the lens of the exposure apparatus and the substrate is filled with air. Thus, the numerical aperture of the lens can be increased, thereby improving the resolution.

Moreover, even in exposure using a lens with a conventional numerical aperture, the depth of focus can be increased, thereby ensuring a stable yield.

Moreover, during resist patterning by liquid immersion lithography, the immersion fluid may penetrate into the resist film (lower layer film), causing resist patterning failure. Resist patterning failure may also occur due to the leaching of various components from the resist film (lower layer film) into the immersion fluid. Further, after the liquid immersion lithography, fluid droplets may remain on the substrate, resulting in patterning defects.

In a conventional method for liquid immersion lithography, an upper layer film is formed on a resist film (lower layer film) to prevent such patterning failure and the like.

There is another conventional method in which a non-topcoat resist film with high water repellency is formed directly on a substrate.

As described above, the resin film including a coating film of the composition for forming a water-repellent film according to the third embodiment of the present disclosure has a low hysteresis with respect to an immersion fluid and a low sliding angle in liquid immersion lithography.

Thus, patterning failure is less likely to occur in the method for forming a resist pattern according to the fourth embodiment of the present disclosure using the composition for forming a water-repellent film according to the third embodiment of the present disclosure.

The steps are described below.

### <Film Formation Step>

In the film formation step, the composition for forming a water-repellent film according to the third embodiment of the present disclosure is applied to a surface of a substrate or a lower layer film (resist film) to form a resin film.

When the composition for forming a water-repellent film according to the third embodiment is applied to a surface of a substrate, the composition for forming a water-repellent film forms a non-topcoat resist film.

When the composition for forming a water-repellent film according to the third embodiment is applied to a surface of a lower layer film (resist film), the composition for forming a water-repellent film forms an upper layer film.

The formation of the resin film may be followed by subjecting the resin film to a heating process.

Non-limiting examples of the substrate include a silicon wafer, a compound semiconductor substrate, and an insulating substrate. The substrate may be one on which an antireflection film has been formed.

Examples of the lower layer film include conventionally known resist films.

The composition for forming a water-repellent film may be applied by any method, including conventionally known methods such as a spin coater or a bar coater.

Although the thickness of the resin film to be formed is not limited, it is preferably 5 to 500 nm.

### <Liquid Immersion Lithography Step>

The resin film with a surface in direct contact with water is exposed to electromagnetic waves or high-energy rays having a wavelength of 300 nm or less through the water.

Thus, the resin film forming a non-topcoat resist film, or the lower layer film (resist film) is exposed.

It should be noted that the liquid immersion lithography may be followed by a baking process.

### <Development Step>

After the liquid immersion lithography step, a development process is performed using a developer. Development refers to the formation of a resist pattern using an alkaline solution (for positive patterning) or an organic solvent (for negative patterning) as the developer to remove the waste material.

### [Positive Patterning]

Positive patterning refers to the formation of a pattern using an alkaline solution as the developer to dissolve and wash away only the exposed portion.

Usually, an aqueous solution of tetramethylammonium hydroxide with a concentration that is 0.1% by mass or more and 10% by mass or less can be used as the alkaline aqueous solution for the developer.

Examples of other alkaline developers include alkaline aqueous solutions in which any of the following is dissolved: sodium hydroxide, potassium hydroxide, sodium carbonate, sodium silicate, sodium metasilicate, ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, pyrrole, piperidine, choline, 1,8-diazabicyclo-[5.4.0]-7-undecene, 1,5-diazabicyclo-[4.3.0]-5-nonane, and the like.

The developer to be used is not limited as long as it can remove the desired waste material by a predetermined developing method, and typical examples include alkali aqueous solutions using inorganic alkalis, primary, secondary, or tertiary amines, quaternary ammonium salts, and mixtures thereof. In addition, water-soluble organic solvents, such as alcohols, including methanol and ethanol, and surfactants can also be added in appropriate amounts to these developers.

In the case where development is carried out using such an alkaline aqueous solution, washing, rinsing, drying, and other processes, if necessary, can be performed to form the desired pattern.

As the developing method, a known method such as immersion method, paddle method, or spray method can be used, and the duration of development may be 0.1 minutes or longer and 3 minutes or shorter. The duration of development is also preferably 0.5 minutes or longer and 2 minutes or shorter.

### [Negative Patterning]

Negative patterning refers to the formation of a pattern using an organic solvent as the developer to dissolve and wash away only the unexposed portion.

Usually, butyl acetate can be used as the organic solvent for the developer.

Examples of other organic solvents include 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, pentyl acetate, butenyl acetate, isopentyl acetate, propyl formate, butyl formate, isobutyl formate, pentyl formate, isopentyl formate, methyl valerate, methyl pentenoate, methyl crotonate, ethyl crotonate, methyl propionate, ethyl propionate, ethyl 3-ethoxypropionate, methyl lactate, ethyl lactate, propyl lactate, butyl lactate, isobutyl lactate, pentyl lactate, isopentyl lactate, methyl 2-hydroxyisobutyrate, ethyl 2-hydroxyisobutyrate, methyl benzoate, ethyl benzoate, phenyl acetate, benzyl acetate, methyl phenylacetate, ethyl phenylacetate, benzyl formate, phenylethyl formate, methyl 3-phenylpropionate, benzyl propionate, and 2-phenylethyl acetate.

The developer to be used is not limited as long as it can remove the waste material by a predetermined developing method. Water-soluble organic solvents, such as alcohols, including methanol and ethanol, and surfactants can also be added in appropriate amounts to such developers.

In the case where development is carried out using such an organic solvent, washing, rinsing, drying, and other processes, if necessary, can be performed to form the desired negative pattern.

As the developing method, a known method such as immersion method, paddle method, or spray method can be used, and the duration of development may be 0.1 minutes or longer and 3 minutes or shorter. The duration of development is also preferably 0.5 minutes or longer and 2 minutes or shorter.

A resist pattern can be formed through the above steps.

It should be noted that the waste liquid resulting from the development step contains the resin with a monochlorodifluoromethyl group (-CF₂Cl) derived from the repeating unit represented by formula (1).

The resin in such a waste liquid easily decomposes, thereby facilitating waste liquid disposal.

### EXAMPLES

The present disclosure will be described in detail with reference to examples below. However, the present disclosure is not limited to the following examples.

In the examples, unless otherwise noted, some compounds are denoted as follows.

Diisobutyl ketone: IPE
Butyl methacrylate: BMA
Tetramethylammonium hydroxide: TMAH
Propylene glycol monomethyl ether acetate: PGMEA
Methyl ethyl ketone: MEK
MA-4FHB-OH: compound represented by the following chemical formula 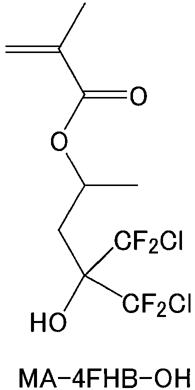
4FIP-M: compound represented by the following chemical formula 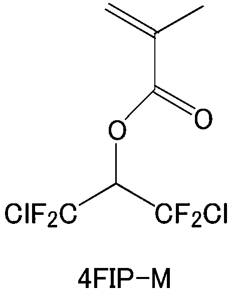
i-4FHK-OH: compound represented by the following chemical formula 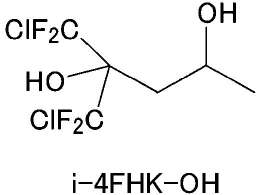
4FIP: compound represented by the following chemical formula 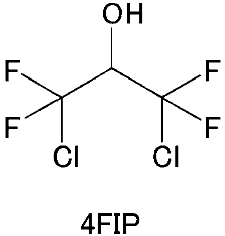
MA-BTHB-OH: compound represented by the following chemical formula 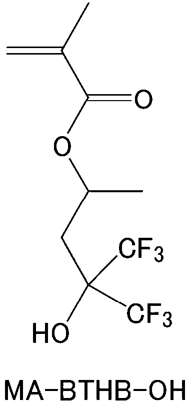
HFIP-M: compound represented by the following chemical formula

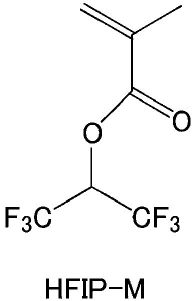

The apparatuses and measurement conditions used for various analyses will be described.

### [Analysis of Fluorine-Containing Polymerizable Monomer]

¹⁹F-NMR and ¹H-NMR measurements were performed using a nuclear magnetic resonance apparatus with a resonance frequency of 400 MHz (hereinafter referred to as NMR, manufactured by JEOL Ltd., equipment name: JNM-ECA400).

### [Analysis of Polymer]

The composition of repeating components in the polymers were determined from the ¹H-NMR and ¹⁹F-NMR measurements obtained by NMR.

### [Analysis of Weight Average Molecular Weight]

The weight average molecular weight (Mw) of the resin compositions and the like described below was measured as follows. The number average molecular weight Mn and molecular weight distribution (the ratio of the mass average molecular weight Mw to the number average molecular weight Mn = Mw/Mn) of the polymers were measured using high performance gel permeation chromatography (hereinafter also referred to as GPC; manufactured by Tosoh Corporation, model HLC-8320GPC) with one ALPHA-M column and one ALPHA-2500 column (both manufactured by Tosoh Corporation) connected in series, and tetrahydrofuran used as the eluent. A differential refractive index detector was used as the detector.

The synthesis of fluorine-containing polymerizable monomers and intermediates for the fluorine-containing polymerizable monomers will be described.

### [Synthesis Example 1: Synthesis of i-4FHK-OH and MA-4FHB-OH]

Concentrated sulfuric acid (0.31 g, 3.16 mmol), acetone (307 g, 5.28 mol), and 1,3-dichlorotetrafluoroacetone (manufactured by SynQuest Laboratories Inc., 210 g, 1.06 mol) were added to a 1 L three-neck eggplant flask and stirred at 30°C overnight. The reaction solution was concentrated with an evaporator at a bath temperature of 30°C under 100 hPa, and the resulting concentrate was washed by adding ion-exchanged water. Thereafter, concentration was performed with an evaporator to obtain a concentrate 1 (245 g).

Tetrahydrofuran (super dehydrated grade, 551 g) and sodium borohydride (32.5 g, 857 mmol) were added to a 1 L three-neck eggplant flask and dispersed, followed by cooling in an ice bath. Thereafter, the concentrate 1 was added dropwise over 30 minutes. After 1.5 hours, the reaction was terminated with aqueous hydrochloric acid. The reaction solution was extracted with IPE (551 g) and washed once with ion-exchanged water. The washed IPE solution was concentrated with an evaporator at a bath temperature of 42°C under 20 hPa while replacing the solvent with toluene to obtain a concentrate 2 (215 g) containing i-4FHK-OH.

The concentrate 2, methanesulfonic acid (5.97 g, 62.1 mmol), and NONFLEX MBP (manufactured by Seiko Chemical Co., Ltd., 0.96 g) were added to a 1 L three-neck eggplant flask and mixed, followed by the dropwise addition of methacrylic anhydride (hereinafter referred to as MAAH, reagent from Tokyo Chemical Industry Co., Ltd., 105 g, 683 mmol) at a bath temperature of 38°C. Thereafter, the mixture was stirred at a bath temperature of 47°C for 1.5 hours and at a bath temperature of 57°C for three hours, and then the reaction was terminated. The reaction solution was extracted with IPE (322 g) and washed once each with aqueous sodium hydroxide and ion-exchanged water. Subsequently, a small amount of 2-methoxyphenothiazine was added, and concentration was performed with an evaporator at a bath temperature of 42°C under 20 hPa. The resulting concentrate was distilled under 0.2 kPa at an internal temperature of 125°C to 136°C to obtain MA-4FHB-OH (123 g, yield 36% (yield over three steps), GC purity >99%). The present reaction is shown below.

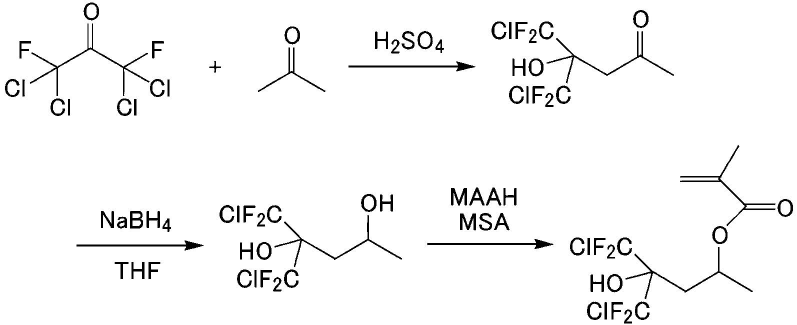

### <NMR Analysis Results>

The NMR results are shown below.
¹H-NMR (CDCl₃, reference substance: TMS): 6.36 ppm (s, 1H), 6.18 ppm (m, 1H), 5.65 ppm (quin, J = 1.6 Hz, 1H), 5.22 ppm (m, 1H), 2.43 ppm (dd, J = 4.8 Hz, 0.8 Hz, 2H), 1.95 ppm (m, 3H), 1.46 ppm (d, J = 6.4 Hz, 3H)
¹⁹F-NMR (CDCl₃, reference substance: C₆F₆): -60.1 ppm (q, 15.2 Hz, 2F), -79.6 ppm (m, 2F)

### [Synthesis Example 2: Synthesis of 4FIP and 4FIP-M]

Sodium borohydride (22.8 g, 603 mmol) and IPE (300 g) were added to a 1 L three-neck eggplant flask, and the mixture was cooled in an ice bath. Thereafter, 1,3-dichlorotetrafluoroacetone (manufactured by SynQuest Laboratories Inc., 100 g, 503 mmol) was slowly added dropwise, and the mixture was stirred at room temperature for 17 hours. After cooling in an ice bath, the reaction was terminated with 200 g of aqueous hydrochloric acid. Thereafter, the organic layer obtained by liquid-liquid separation was subjected to atmospheric distillation (oil bath 120°C to 150°C), thereby obtaining 129 g of a solution of 4FIP in IPE. The purity was 64 wt%, and the yield was 82%. The present reaction is shown below.

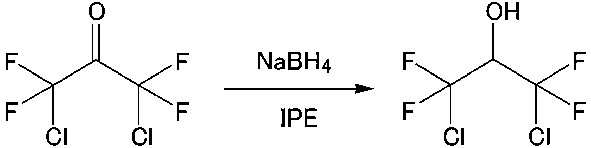

### <NMR Analysis Results>

The NMR results are shown below. The results for 4FIP only are shown.
¹H-NMR (CDCl₃, reference substance: TMS): 4.42 ppm (m, 1H)
¹⁹F-NMR (CDCl₃, reference substance: C₆F₆): -58.7 ppm (m, 2F), -63.4 ppm (m, 2F)

A solution of 4FIP in IPE (120 g, 410 mmol), triethylamine (46 g, 454 mmol), and IPE (150 g) were added to a 500 mL three-neck eggplant flask and cooled in an ice bath. Subsequently, methacryloyl chloride (45 g, 45.2 mmol) was slowly added dropwise, and the mixture was then stirred at room temperature for three hours. Then, the reaction was terminated with 200 g of saturated aqueous sodium bicarbonate. Thereafter, the organic layer obtained by liquid-liquid separation was washed once with 200 g of saturated aqueous sodium bicarbonate and twice with 200 g of distilled water, and then subjected to distillation under reduced pressure (pressure reduction 0.6 kPa, oil bath 50°C to 100°C) to obtain 86 g of 4FIP-M. The yield was 80%, and the GC purity was >99%. The present reaction is shown below.

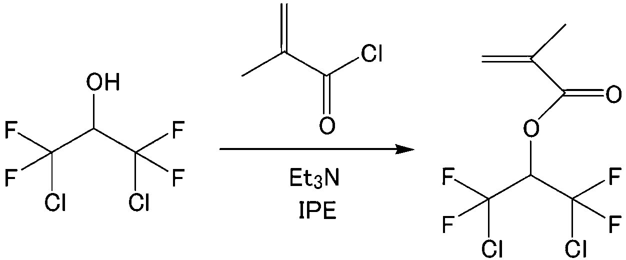

### <NMR Analysis Results>

The NMR results are shown below.
¹H-NMR (CDCl₃, reference substance: TMS): 6.36 ppm (m, 1H), 5.89 ppm (m, 1H), 5.84 ppm (m, 1H), 2.03 ppm (m, 3H)
¹⁹F-NMR (CDCl₃, reference substance: C₆F₆): -58.5 ppm (m, 2F), -60.1 ppm (m, 2F)

Next, the synthesis of polymers will be described.

### [Example 1-1: Synthesis of Copolymer 1-1]

MEK (75.6 g) was added to a 300 mL three-neck flask, and the internal temperature was increased to 80°C. Subsequently, a mixed solution of MA-4FHB-OH (8.2 g, 25 mmol), BMA (10.7 g, 75 mmol), and MEK (18.9 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 14.2 g of a white powder. A copolymer 1-1 according to Example 1-1 was synthesized through the above steps.

### [Example 1-2 and Example 1-3: Synthesis of Copolymer 1-2 and Copolymer 1-3]

A copolymer 1-2 and a copolymer 1-3 according to Example 1-2 and Example 1-3, respectively, were synthesized as in Example 1-1, except that the proportions (molar proportions) of MA-4FHB-OH and BMA used were changed as shown in Table 1.

### [Example 1-4: Synthesis of Copolymer 1-4]

MEK (83.3 g) was added to a 300 mL three-neck flask, and the internal temperature was increased to 80°C. Subsequently, a mixed solution of MA-4FHB-OH (8.2 g, 25 mmol), 1-methylcyclopentyl methacrylate (12.6 g, 75 mmol), and MEK (20.8 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 16.0 g of a white powder. A copolymer 1-4 according to Example 1-4 was synthesized through the above steps.

### [Example 1-5 and Example 1-6: Synthesis of Copolymer 1-5 and Copolymer 1-6]

A copolymer 1-5 and a copolymer 1-6 according to Example 1-5 and Example 1-6, respectively, were synthesized as in Example 1-4, except that the proportions (molar proportions) of MA-4FHB-OH and 1-methylcyclopentyl methacrylate used were changed as shown in Table 1.

### [Example 1-7: Synthesis of Copolymer 1-7]

MEK (87.5 g) was added to a 300 mL three-neck flask, and the internal temperature was increased to 80°C. Subsequently, a mixed solution of MA-4FHB-OH (8.2 g, 25 mmol), 1-ethylcyclopentyl methacrylate (13.7 g, 75 mmol), and MEK (21.9 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 17.3 g of a white powder. A copolymer 1-7 according to Example 1-7 was synthesized through the above steps.

### [Example 1-8 and Example 1-9: Synthesis of Copolymer 1-8 and Copolymer 1-9]

A copolymer 1-8 and a copolymer 1-9 according to Example 1-8 and Example 1-9, respectively, were synthesized as in Example 1-7, except that the proportions (molar proportions) of MA-4FHB-OH and 1-ethylcyclopentyl methacrylate used were changed as shown in Table 1.

### [Example 1-10: Synthesis of Copolymer 1-10]

MEK (103.1 g) was added to a 300 mL three-neck flask, and the internal temperature was increased to 80°C. Subsequently, a mixed solution of MA-4FHB-OH (8.2 g, 25 mmol), 2-methyl-2-adamantyl methacrylate (17.5 g, 75 mmol), and MEK (25.8 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 19.3 g of a white powder. A copolymer 1-10 according to Example 1-10 was synthesized through the above steps.

### [Example 1-11 and Example 1-12: Synthesis of Copolymer 1-11 and Copolymer 1-12]

A copolymer 1-11 and a copolymer 1-12 according to Example 1-11 and Example 1-12, respectively, were synthesized as in Example 1-10, except that the proportions (molar proportions) of MA-4FHB-OH and 2-methyl-2-adamantyl methacrylate used were changed as shown in Table 1.

### [Example 1-13: Synthesis of Copolymer 1-13]

MEK (104.0 g) was added to a 300 mL three-neck flask, and the internal temperature was increased to 80°C. Subsequently, a mixed solution of MA-4FHB-OH (8.2 g, 25 mmol), 2-ethyl-2-adamantyl methacrylate (17.8 g, 75 mmol), and MEK (26.8 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 19.8 g of a white powder. A copolymer 1-13 according to Example 1-13 was synthesized through the above steps.

### [Example 1-14 and Example 1-15: Synthesis of Copolymer 1-14 and Copolymer 1-15]

A copolymer 1-14 and a copolymer 1-15 according to Example 1-14 and Example 1-15, respectively, were synthesized as in Example 1-13, except that the proportions (molar proportions) of MA-4FHB-OH and 2-ethyl-2-adamantyl methacrylate used were changed as shown in Table 1.

### [Example 1-16: Synthesis of Copolymer 1-16]

MEK (58.6 g) was added to a 300 mL three-neck flask, and the internal temperature was increased to 80°C. Subsequently, a mixed solution of MA-4FHB-OH (8.2 g, 25 mmol), methacrylic acid (6.5 g, 75 mmol), and MEK (14.7 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 8.8 g of a white powder. A copolymer 1-16 according to Example 1-16 was synthesized through the above steps.

### [Example 1-17 and Example 1-18: Synthesis of Copolymer 1-17 and Copolymer 1-18]

A copolymer 1-17 and a copolymer 1-18 according to Example 1-17 and Example 1-18, respectively, were synthesized as in Example 1-16, except that the proportions (molar proportions) of MA-4FHB-OH and methacrylic acid used were changed as shown in Table 1.

### [Comparative Example 1-1: Synthesis of Comparative Copolymer 1-1]

MEK (72.4 g) was added to a 300 mL three-neck flask, and the internal temperature was increased to 80°C. Subsequently, a mixed solution of MA-BTHB-OH (7.4 g, 25 mmol), BMA (10.7 g, 75 mmol), and MEK (18.1 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (200 g) was added to the solution. The resulting solution was then added dropwise to heptane (20 g), followed by reprecipitation and filtration to obtain a polymer. The polymer was dried under reduced pressure to obtain 13.2 g of a white powder. A comparative copolymer 1-1 according to Comparative Example 1-1 was synthesized through the above steps.

### [Comparative Example 1-2 and Comparative Example 1-3: Synthesis of Comparative Copolymer 1-2 and Comparative Copolymer 1-3]

A comparative copolymer 1-2 and a comparative copolymer 1-3 according to Comparative Example 1-2 and Comparative Example 1-3, respectively, were synthesized as in Comparative Example 1-1, except that the proportions (molar proportions) of MA-BTHB-OH and BMA used were changed as shown in Table 1.

### [Comparative Example 1-4: Synthesis of Comparative Copolymer 1-4]

MEK (80.1 g) was added to a 300 mL three-neck flask, and the internal temperature was increased to 80°C. Subsequently, a mixed solution of MA-BTHB-OH (7.4 g, 25 mmol), 1-methylcyclopentyl methacrylate (12.6 g, 75 mmol), and MEK (20.0 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 15.9 g of a white powder. A comparative copolymer 1-4 according to Comparative Example 1-4 was synthesized through the above steps.

### [Comparative Example 1-5 and Comparative Example 1-6: Synthesis of Comparative Copolymer 1-5 and Comparative Copolymer 1-6]

A comparative copolymer 1-5 and a comparative copolymer 1-6 according to Comparative Example 1-5 and Comparative Example 1-6, respectively, were synthesized as in Comparative Example 1-4, except that the proportions (molar proportions) of MA-BTHB-OH and 1-methylcyclopentyl methacrylate used were changed as shown in Table 1.

### [Comparative Example 1-7: Synthesis of Comparative Copolymer 1-7]

MEK (84.4 g) was added to a 300 mL three-neck flask, and the internal temperature was increased to 80°C. Subsequently, a mixed solution of MA-BTHB-OH (7.4 g, 25 mmol), 1-ethylcyclopentyl methacrylate (13.7 g, 75 mmol), and MEK (21.1 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 17.2 g of a white powder. A comparative copolymer 1-7 according to Comparative Example 1-7 was synthesized through the above steps.

### [Comparative Example 1-8 and Comparative Example 1-9: Synthesis of Comparative Copolymer 1-8 and Comparative Copolymer 1-9]

A comparative copolymer 1-8 and a comparative copolymer 1-9 according to Comparative Example 1-8 and Comparative Example 1-9, respectively, were synthesized as in Comparative Example 1-7, except that the proportions (molar proportions) of MA-BTHB-OH and 1-ethylcyclopentyl methacrylate used were changed as shown in Table 1.

### [Comparative Example 1-10: Synthesis of Comparative Copolymer 1-10]

MEK (99.9 g) was added to a 300 mL three-neck flask, and the internal temperature was increased to 80°C. Subsequently, a mixed solution of MA-BTHB-OH (7.4 g, 25 mmol), 2-methyl-2-adamantyl methacrylate (16.8 g, 75 mmol), and MEK (25.0 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 19.2 g of a white powder. A comparative copolymer 1-10 according to Comparative Example 1-10 was synthesized through the above steps.

### [Comparative Example 1-11 and Comparative Example 1-12: Synthesis of Comparative Copolymer 1-11 and Comparative Copolymer 1-12]

A comparative copolymer 1-11 and a comparative copolymer 1-12 according to Comparative Example 1-11 and Comparative Example 1-12, respectively, were synthesized as in Comparative Example 1-10, except that the proportions (molar proportions) of MA-BTHB-OH and 2-methyl-2-adamantyl methacrylate used were changed as shown in Table 1.

### [Comparative Example 1-13: Synthesis of Comparative Copolymer 1-13]

MEK (95.6 g) was added to a 300 mL three-neck flask, and the internal temperature was increased to 80°C. Subsequently, a mixed solution of MA-BTHB-OH (7.4 g, 25 mmol), 2-ethyl-2-adamantyl methacrylate (17.8 g, 75 mmol), and MEK (26.0 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 19.5 g of a white powder. A comparative copolymer 1-13 according to Comparative Example 1-13 was synthesized through the above steps.

### [Comparative Example 1-14 and Comparative Example 1-15: Synthesis of Comparative Copolymer 1-14 and Comparative Copolymer 1-15]

A comparative copolymer 1-14 and a comparative copolymer 1-15 according to Comparative Example 1-14 and Comparative Example 1-15, respectively, were synthesized as in Comparative Example 1-13, except that the proportions (molar proportions) of MA-BTHB-OH and 2-ethyl-2-adamantyl methacrylate used were changed as shown in Table 1.

### [Comparative Example 1-16: Synthesis of Comparative Copolymer 1-16]

MEK (55.4 g) was added to a 300 mL three-neck flask, and the internal temperature was increased to 80°C. Subsequently, a mixed solution of MA-BTHB-OH (7.4 g, 25 mmol), methacrylic acid (6.5 g, 75 mmol), and MEK (13.9 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 7.5 g of a white powder. A comparative copolymer 1-16 according to Comparative Example 1-16 was synthesized through the above steps.

### [Comparative Example 1-17 and Comparative Example 1-18: Synthesis of Comparative Copolymer 1-17 and Comparative Copolymer 1-18]

A comparative copolymer 1-17 and a comparative copolymer 1-18 according to Comparative Example 1-17 and Comparative Example 1-18, respectively, were synthesized as in Comparative Example 1-16, except that the proportions (molar proportions) of MA-BTHB-OH and methacrylic acid used were changed as shown in Table 1.

**[Table 1]**

| | Polymerizable monomer (mol%) | | | | | | | |
|---|---|---|---|---|---|---|---|---|
| | MA-4FHB-OH | MA-BTHB-OH | BMA | 1-Methylcyclopentyl methacrylate | 1-Ethylcyclopentyl methacrylate | 2-Methyl-2-adamantyl methacrylate | 2-Ethyl-2-adamantyl methacrylate | Methacrylic acid |
| Example 1-1 | 25 | - | 75 | - | - | - | - | - |
| Example 1-2 | 50 | - | 50 | - | - | - | - | - |
| Example 1-3 | 75 | - | 25 | - | - | - | - | - |
| Example 1-4 | 25 | - | - | 75 | - | - | - | - |
| Example 1-5 | 50 | - | - | 50 | - | - | - | - |
| Example 1-6 | 75 | - | - | 25 | - | - | - | - |
| Example 1-7 | 25 | - | - | - | 75 | - | - | - |
| Example 1-8 | 50 | - | - | - | 50 | - | - | - |
| Example 1-9 | 75 | - | - | - | 25 | - | - | - |
| Example 1-10 | 25 | - | - | - | - | 75 | - | - |
| Example 1-11 | 50 | - | - | - | - | 50 | - | - |
| Example 1-12 | 75 | - | - | - | - | 25 | - | - |
| Example 1-13 | 25 | - | - | - | - | - | 75 | - |
| Example 1-14 | 50 | - | - | - | - | - | 50 | - |
| Example 1-15 | 75 | - | - | - | - | - | 25 | - |
| Example 1-16 | 25 | - | - | - | - | - | - | 75 |
| Example 1-17 | 50 | - | - | - | - | - | - | 50 |
| Example 1-18 | 75 | - | - | - | - | - | - | 25 |
| Comparative Example 1-1 | - | 25 | 75 | - | - | - | - | - |
| Comparative Example 1-2 | - | 50 | 50 | - | - | - | - | - |
| Comparative Example 1-3 | - | 75 | 25 | - | - | - | - | - |
| Comparative Example 1-4 | - | 25 | - | 75 | - | - | - | - |
| Comparative Example 1-5 | - | 50 | - | 50 | - | - | - | - |
| Comparative Example 1-6 | - | 75 | - | 25 | - | - | - | - |
| Comparative Example 1-7 | - | 25 | - | - | 75 | - | - | - |
| Comparative Example 1-8 | - | 50 | - | - | 50 | - | - | - |
| Comparative Example 1-9 | - | 75 | - | - | 25 | - | - | - |
| Comparative Example 1-10 | - | 25 | - | - | - | 75 | - | - |
| Comparative Example 1-11 | - | 50 | - | - | - | 50 | - | - |
| Comparative Example 1-12 | - | 75 | - | - | - | 25 | - | |
| Comparative Example 1-13 | - | 25 | - | - | - | - | 75 | - |
| Comparative Example 1-14 | - | 50 | - | - | - | - | 50 | - |
| Comparative Example 1-15 | - | 75 | - | - | - | - | 25 | - |
| Comparative Example 1-16 | - | 25 | - | - | - | - | - | 75 |
| Comparative Example 1-17 | - | 50 | - | - | - | - | - | 50 |
| Comparative Example 1-18 | - | 75 | - | - | - | - | - | 25 |

| | Mw | PDI | Contact angle (°) | | | | Sliding angle (°) | Evaluation of solubility in alkaline developer |
|---|---|---|---|---|---|---|---|---|
| | | | Static | Hysteresis (Advancing - Receding) | Advancing | Receding | | |
| Example 1-1 | 10900 | 1.73 | 92 | 16 | 94 | 78 | 19 | Insoluble |
| Example 1-2 | 10700 | 1.73 | 92 | 15 | 94 | 79 | 19 | Insoluble |
| Example 1-3 | 10700 | 1.74 | 92 | 16 | 94 | 78 | 18 | Soluble |
| Example 1-4 | 10100 | 1.72 | 94 | 15 | 94 | 79 | 17 | Insoluble |
| Example 1-5 | 9900 | 1.74 | 94 | 15 | 94 | 79 | 17 | Insoluble |
| Example 1-6 | 9800 | 1.75 | 95 | 14 | 94 | 80 | 18 | Soluble |
| Example 1-7 | 9900 | 1.72 | 92 | 15 | 92 | 77 | 18 | Insoluble |
| Example 1-8 | 10000 | 1.73 | 92 | 16 | 92 | 76 | 18 | Insoluble |
| Example 1-9 | 10200 | 1.74 | 93 | 17 | 93 | 76 | 18 | Soluble |
| Example 1-10 | 10100 | 1.74 | 92 | 16 | 93 | 77 | 19 | Insoluble |
| Example 1-11 | 10200 | 1.72 | 92 | 16 | 93 | 77 | 19 | Insoluble |
| Example 1-12 | 10200 | 1.73 | 92 | 16 | 93 | 77 | 19 | Soluble |
| Example 1-13 | 9800 | 1.74 | 91 | 16 | 92 | 76 | 20 | Insoluble |
| Example 1-14 | 9900 | 1.73 | 91 | 16 | 92 | 76 | 20 | Insoluble |
| Example 1-15 | 10000 | 1.74 | 91 | 17 | 92 | 75 | 20 | Soluble |
| Example 1-16 | 9800 | 1.72 | 88 | 16 | 93 | 77 | 20 | Soluble |
| Example 1-17 | 9900 | 1.73 | 91 | 17 | 94 | 77 | 20 | Soluble |
| Example 1-18 | 10000 | 1.74 | 92 | 16 | 94 | 78 | 20 | Soluble |
| Comparative Example 1-1 | 10800 | 1.72 | 88 | 18 | 91 | 73 | 22 | Insoluble |
| Comparative Example 1-2 | 10800 | 1.73 | 88 | 19 | 92 | 73 | 23 | Insoluble |
| Comparative Example 1-3 | 10700 | 1.74 | 88 | 18 | 92 | 74 | 23 | Soluble |
| Comparative Example 1-4 | 10000 | 1.74 | 90 | 21 | 91 | 70 | 22 | Insoluble |
| Comparative Example 1-5 | 10100 | 1.71 | 90 | 20 | 91 | 71 | 23 | Insoluble |
| Comparative Example 1-6 | 9900 | 1.73 | 90 | 19 | 92 | 73 | 23 | Soluble |
| Comparative Example 1-7 | 10000 | 1.72 | 88 | 19 | 92 | 73 | 24 | Insoluble |
| Comparative Example 1-8 | 9800 | 1.74 | 88 | 19 | 89 | 70 | 24 | Insoluble |
| Comparative Example 1-9 | 10300 | 1.75 | 88 | 19 | 89 | 70 | 24 | Soluble |
| Comparative Example 1-10 | 10000 | 1.72 | 86 | 21 | 89 | 68 | 25 | Insoluble |
| Comparative Example 1-11 | 10300 | 1,73 | 86 | 21 | 86 | 65 | 24 | Insoluble |
| Comparative Example 1-12 | 10200 | 1.72 | 87 | 21 | 87 | 66 | 24 | Soluble |
| Comparative Example 1-13 | 10100 | 1.74 | 85 | 21 | 87 | 66 | 26 | Insoluble |
| Comparative Example 1-14 | 9900 | 1.73 | 85 | 20 | 87 | 67 | 25 | Insoluble |
| Comparative Example 1-15 | 10000 | 1.71 | 84 | 20 | 87 | 67 | 25 | Soluble |
| Comparative Example 1-16 | 9700 | 1.78 | 82 | 25 | 88 | 63 | 25 | Soluble |
| Comparative Example 1-17 | 9900 | 1.77 | 83 | 24 | 87 | 63 | 25 | Soluble |
| Comparative Example 1-18 | 9800 | 1.77 | 84 | 22 | 87 | 65 | 22 | Soluble |

### [Example 2-1: Synthesis of Copolymer 2-1]

MEK (69.6 g) was added to a 300 mL three-neck flask, and the internal temperature was increased to 80°C. Subsequently, a mixed solution of 4FIP-M (6.7 g, 25 mmol) and BMA (10.7 g, 75 mmol) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 12.2 g of a white powder. A copolymer 2-1 according to Example 2-1 was synthesized through the above steps.

### [Example 2-2 and Example 2-3: Synthesis of Copolymer 2-2 and Copolymer 2-3]

A copolymer 2-2 and a copolymer 2-3 according to Example 2-2 and Example 2-3, respectively, were synthesized as in Example 2-1, except that the proportions (molar proportions) of 4FIP-M and BMA used were changed as shown in Table 2.

### [Example 2-4: Synthesis of Copolymer 2-4]

MEK (73.2 g) was added to a 300 mL three-neck flask, and the internal temperature was increased to 80°C. Subsequently, a mixed solution of 4FIP-M (6.7 g, 25 mmol), 1-methylcyclopentyl methacrylate (12.6 g, 75 mmol), and MEK (19.3 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 14.1 g of a white powder. A copolymer 2-4 according to Example 2-4 was synthesized through the above steps.

### [Example 2-5 and Example 2-6: Synthesis of Copolymer 2-5 and Copolymer 2-6]

A copolymer 2-5 and a copolymer 2-6 according to Example 2-5 and Example 2-6, respectively, were synthesized as in Example 2-4, except that the proportions (molar proportions) of 4FIP-M and 1-methylcyclopentyl methacrylate used were changed as shown in Table 2.

### [Example 2-7: Synthesis of Copolymer 2-7]

MEK (81.6 g) was added to a 300 mL three-neck flask, and the internal temperature was increased to 80°C. Subsequently, a mixed solution of 4FIP-M (6.7 g, 25 mmol), 1-ethylcyclopentyl methacrylate (13.7 g, 75 mmol), and MEK (20.4 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 15.1 g of a white powder. A copolymer 2-7 according to Example 2-7 was synthesized through the above steps.

### [Example 2-8 and Example 2-9: Synthesis of Copolymer 2-8 and Copolymer 2-9]

A copolymer 2-8 and a copolymer 2-9 according to Example 2-8 and Example 2-9, respectively, were synthesized as in Example 2-7, except that the proportions (molar proportions) of 4FIP-M and 1-ethylcyclopentyl methacrylate used were changed as shown in Table 2.

### [Example 2-10: Synthesis of Copolymer 2-10]

MEK (92.8 g) was added to a 300 mL three-neck flask, and the internal temperature was increased to 80°C. Subsequently, a mixed solution of 4FIP-M (6.7 g, 25 mmol), 2-methyl-2-adamantyl methacrylate (17.5 g, 75 mmol), and MEK (24.2 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 18.3 g of a white powder. A copolymer 2-10 according to Example 2-10 was synthesized through the above steps.

### [Example 2-11 and Example 2-12: Synthesis of Copolymer 2-11 and Copolymer 2-12]

A copolymer 2-11 and a copolymer 2-12 according to Example 2-11 and Example 2-12, respectively, were synthesized as in Example 2-10, except that the proportions (molar proportions) of 4FIP-M and 2-methyl-2-adamantyl methacrylate used were changed as shown in Table 2.

### [Example 2-13: Synthesis of Copolymer 2-13]

MEK (101.6 g) was added to a 300 mL three-neck flask, and the internal temperature was increased to 80°C. Subsequently, a mixed solution of 4FIP-M (6.7 g, 25 mmol), 2-ethyl-2-adamantyl methacrylate (17.8 g, 75 mmol), and MEK (25.4 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 17.8 g of a white powder. A copolymer 2-13 according to Example 2-13 was synthesized through the above steps.

### [Example 2-14 and Example 2-15: Synthesis of Copolymer 2-14 and Copolymer 2-15]

A copolymer 2-14 and a copolymer 2-15 according to Example 2-14 and Example 2-15, respectively, were synthesized as in Example 2-13, except that the proportions (molar proportions) of 4FIP-M and 2-ethyl-2-adamantyl methacrylate used were changed as shown in Table 2.

### [Example 2-16: Synthesis of Copolymer 2-16]

MEK (52.7 g) was added to a 300 mL three-neck flask, and the internal temperature was increased to 80°C. Subsequently, a mixed solution of 4FIP-M (6.7 g, 25 mmol), methacrylic acid (6.5 g, 75 mmol), and MEK (13.2 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 8.8 g of a white powder. A copolymer 2-16 according to Example 2-16 was synthesized through the above steps.

### [Example 2-17 and Example 2-18: Synthesis of Copolymer 2-17 and Copolymer 2-18]

A copolymer 2-17 and a copolymer 2-18 according to Example 2-17 and Example 2-18, respectively, were synthesized as in Example 2-16, except that the proportions (molar proportions) of 4FIP-M and methacrylic acid used were changed as shown in Table 2.

### [Comparative Example 2-1: Synthesis of Comparative Copolymer 2-1]

MEK (66.3 g) was added to a 300 mL three-neck flask, and the internal temperature was increased to 80°C. Subsequently, a mixed solution of HFIP-M (5.9 g, 25 mmol) and BMA (10.7 g, 75 mmol) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 12.0 g of a white powder. A comparative copolymer 2-1 according to Comparative Example 2-1 was synthesized through the above steps.

### [Comparative Example 2-2 and Comparative Example 2-3: Synthesis of Comparative Copolymer 2-2 and Comparative Copolymer 2-3]

A comparative copolymer 2-2 and a comparative copolymer 2-3 according to Comparative Example 2-2 and Comparative Example 2-3, respectively, were synthesized as in Comparative Example 2-1, except that the proportions (molar proportions) of HFIP-M and BMA used were changed as shown in Table 2.

### [Comparative Example 2-4: Synthesis of Comparative Copolymer 2-4]

MEK (76.8 g) was added to a 300 mL three-neck flask, and the internal temperature was increased to 80°C. Subsequently, a mixed solution of HFIP-M (5.9 g, 25 mmol), 1-methylcyclopentyl methacrylate (12.6 g, 75 mmol), and MEK (18.5 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 14.9 g of a white powder. A comparative copolymer 2-4 according to Comparative Example 2-4 was synthesized through the above steps.

### [Comparative Example 2-5 and Comparative Example 2-6: Synthesis of Comparative Copolymer 2-5 and Comparative Copolymer 2-6]

A comparative copolymer 2-5 and a comparative copolymer 2-6 according to Comparative Example 2-5 and Comparative Example 2-6, respectively, were synthesized as in Comparative Example 2-4, except that the proportions (molar proportions) of HFIP-M and 1-methylcyclopentyl methacrylate used were changed as shown in Table 2.

### [Comparative Example 2-7: Synthesis of Comparative Copolymer 2-7]

MEK (80.8 g) was added to a 300 mL three-neck flask, and the internal temperature was increased to 80°C. Subsequently, a mixed solution of HFIP-M (5.9 g, 25 mmol), 1-ethylcyclopentyl methacrylate (13.7 g, 75 mmol), and MEK (19.6 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 17.1 g of a white powder. A comparative copolymer 2-7 according to Comparative Example 2-7 was synthesized through the above steps.

### [Comparative Example 2-8 and Comparative Example 2-9: Synthesis of Comparative Copolymer 2-8 and Comparative Copolymer 2-9]

A comparative copolymer 2-8 and a comparative copolymer 2-9 according to Comparative Example 2-8 and Comparative Example 2-9, respectively, were synthesized as in Comparative Example 2-7, except that the proportions (molar proportions) of HFIP-M and 1-ethylcyclopentyl methacrylate used were changed as shown in Table 2.

### [Comparative Example 2-10: Synthesis of Comparative Copolymer 2-10]

MEK (96.8 g) was added to a 300 mL three-neck flask, and the internal temperature was increased to 80°C. Subsequently, a mixed solution of HFIP-M (5.9 g, 25 mmol), 2-methyl-2-adamantyl methacrylate (16.8 g, 75 mmol), and MEK (22.7 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 19.0 g of a white powder. A comparative copolymer 2-10 according to Comparative Example 2-10 was synthesized through the above steps.

### [Comparative Example 2-11 and Comparative Example 2-12: Synthesis of Comparative Copolymer 2-11 and Comparative Copolymer 2-12]

A comparative copolymer 2-11 and a comparative copolymer 2-12 according to Comparative Example 2-11 and Comparative Example 2-12, respectively, were synthesized as in Comparative Example 2-10, except that the proportions (molar proportions) of HFIP-M and 2-methyl-2-adamantyl methacrylate used were changed as shown in Table 2.

### [Comparative Example 2-13: Synthesis of Comparative Copolymer 2-13]

MEK (100.8 g) was added to a 300 mL three-neck flask, and the internal temperature was increased to 80°C. Subsequently, a mixed solution of HFIP-M (5.9 g, 25 mmol), 2-ethyl-2-adamantyl methacrylate (17.8 g, 75 mmol), and MEK (23.7 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 19.2 g of a white powder. A comparative copolymer 2-13 according to Comparative Example 2-13 was synthesized through the above steps.

### [Comparative Example 2-14 and Comparative Example 2-15: Synthesis of Comparative Copolymer 2-14 and Comparative Copolymer 2-15]

A comparative copolymer 2-14 and a comparative copolymer 2-15 according to Comparative Example 2-14 and Comparative Example 2-15, respectively, were synthesized as in Comparative Example 2-13, except that the proportions (molar proportions) of HFIP-M and 2-ethyl-2-adamantyl methacrylate used were changed as shown in Table 2.

### [Comparative Example 2-16: Synthesis of Comparative Copolymer 2-16]

MEK (49.4 g) was added to a 300 mL three-neck flask, and the internal temperature was increased to 80°C. Subsequently, a mixed solution of HFIP-M (5.9 g, 25 mmol), methacrylic acid (6.5 g, 75 mmol), and MEK (12.4 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 6.2 g of a white powder. A comparative copolymer 2-16 according to Comparative Example 2-16 was synthesized through the above steps.

### [Comparative Example 2-17 and Comparative Example 2-18: Synthesis of Comparative Copolymer 2-17 and Comparative Copolymer 2-18]

A comparative copolymer 2-17 and a comparative copolymer 2-18 according to Comparative Example 2-17 and Comparative Example 2-18, respectively, were synthesized as in Comparative Example 2-16, except that the proportions (molar proportions) of HFIP-M and methacrylic acid used were changed as shown in Table 2.

**[Table 2]**

| | Polymerizable monomer (mol%) | | | | | | | |
|---|---|---|---|---|---|---|---|---|
| | 4FIP-M | HFIP-M | BMA | 1-Methylcyclopentyl methacrylate | 1-Ethylcyclopentyl methacrylate | 2-Methyl-2-adamantyl methacrylate | 2-Ethyl-2-adamantyl methacrylate | Methacrylic acid |
| Example 2-1 | 25 | - | 75 | - | - | - | - | - |
| Example 2-2 | 50 | - | 50 | - | - | - | - | - |
| Example 2-3 | 75 | - | 25 | - | - | - | - | - |
| Example 2-4 | 25 | - | - | 75 | - | - | - | - |
| Example 2-5 | 50 | - | - | 50 | - | - | - | - |
| Example 2-6 | 75 | - | - | 25 | - | - | - | - |
| Example 2-7 | 25 | - | - | - | 75 | - | - | - |
| Example 2-8 | 50 | - | - | - | 50 | - | - | - |
| Example 2-9 | 75 | - | - | - | 25 | - | - | - |
| Example 2-10 | 25 | - | - | - | - | 75 | - | - |
| Example 2-11 | 50 | - | - | - | - | 50 | - | - |
| Example 2-12 | 75 | - | - | - | - | 25 | - | - |
| Example 2-13 | 25 | - | - | - | - | - | 75 | - |
| Example 2-14 | 50 | - | - | - | - | - | 50 | - |
| Example 2-15 | 75 | - | - | - | - | - | 25 | - |
| Example 2-16 | 25 | - | - | - | - | - | - | 75 |
| Example 2-17 | 50 | - | - | - | - | - | - | 50 |
| Example 2-18 | 75 | - | - | - | - | - | - | 25 |
| Comparative Example 2-1 | - | 25 | 75 | - | - | - | - | - |
| Comparative Example 2-2 | - | 50 | 50 | - | - | - | - | - |
| Comparative Example 2-3 | - | 75 | 25 | - | - | - | - | - |
| Comparative Example 2-4 | - | 25 | - | 75 | - | - | - | - |
| Comparative Example 2-5 | - | 50 | - | 50 | - | - | - | - |
| Comparative Example 2-6 | - | 75 | - | 25 | - | - | - | - |
| Comparative Example 2-7 | - | 25 | - | - | 75 | - | - | - |
| Comparative Example 2-8 | - | 50 | - | - | 50 | - | - | - |
| Comparative Example 2-9 | - | 75 | - | - | 25 | - | - | - |
| Comparative Example 2-10 | - | 25 | - | - | - | 75 | - | - |
| Comparative Example 2-11 | - | 50 | - | - | - | 50 | - | - |
| Comparative Example 2-12 | - | 75 | - | - | - | 25 | - | - |
| Comparative Example 2-13 | - | 25 | - | - | - | - | 75 | - |
| Comparative Example 2-14 | - | 50 | - | - | - | - | 50 | - |
| Comparative Example 2-15 | - | 75 | - | - | - | - | 25 | - |
| Comparative Example 2-16 | - | 25 | - | - | - | - | - | 75 |
| Comparative Example 2-17 | - | 50 | - | - | - | - | - | 50 |
| Comparative Example 2-18 | - | 75 | - | - | - | - | - | 25 |

| | Mw | PDI | Contact angle (°) | | | | Sliding angle (°) | |
|---|---|---|---|---|---|---|---|---|
| | | | Static | Hysteresis (Advancing - Receding) | Advancing | Receding | | |
| Example 2-1 | 10500 | 1.69 | 95 | 8 | 100 | 92 | 9 | |
| Example 2-2 | 10500 | 1.71 | 98 | 7 | 102 | 95 | 8 | |
| Example 2-3 | 10300 | 1.71 | 100 | 8 | 104 | 96 | 7 | |
| Example 2-4 | 10100 | 1.73 | 97 | 10 | 100 | 90 | 10 | |
| Example 2-5 | 10300 | 1.69 | 97 | 10 | 100 | 90 | 9 | |
| Example 2-6 | 10200 | 1.71 | 98 | 10 | 100 | 90 | 9 | |
| Example 2-7 | 10000 | 1.73 | 95 | 11 | 98 | 87 | 11 | |
| Example 2-8 | 9800 | 1.74 | 95 | 11 | 98 | 87 | 10 | |
| Example 2-9 | 10100 | 1.71 | 96 | 12 | 99 | 87 | 10 | |
| Example 2-10 | 9900 | 1.74 | 95 | 12 | 99 | 87 | 9 | |
| Example 2-11 | 10300 | 1.68 | 95 | 11 | 99 | 88 | 9 | |
| Example 2-12 | 10000 | 1.69 | 95 | 11 | 99 | 88 | 9 | |
| Example 2-13 | 9900 | 1.71 | 94 | 12 | 98 | 86 | 11 | |
| Example 2-14 | 10200 | 1.75 | 94 | 11 | 98 | 87 | 10 | |
| Example 2-15 | 10300 | 1.73 | 94 | 10 | 98 | 88 | 11 | |
| Example 2-16 | 10000 | 1.73 | 94 | 11 | 95 | 84 | 12 | |
| Example 2-17 | 9900 | 1.72 | 95 | 11 | 98 | 87 | 10 | |
| Example 2-18 | 9900 | 1.72 | 96 | 11 | 98 | 87 | 10 | |
| Comparative Example 2-1 | 10500 | 1.71 | 97 | 10 | 105 | 95 | 12 | |
| Comparative Example 2-2 | 10400 | 1.73 | 100 | 10 | 107 | 97 | 11 | |
| Comparative Example 2-3 | 10300 | 1.72 | 102 | 11 | 109 | 98 | 10 | |
| Comparative Example 2-4 | 10000 | 1.71 | 93 | 15 | 95 | 80 | 14 | |
| Comparative Example 2-5 | 10100 | 1.73 | 93 | 15 | 96 | 81 | 14 | |
| Comparative Example 2-6 | 10100 | 1.69 | 93 | 16 | 96 | 80 | 14 | |
| Comparative Example 2-7 | 10000 | 1.68 | 91 | 16 | 95 | 79 | 14 | |
| Comparative Example 2-8 | 9900 | 1.72 | 91 | 16 | 94 | 78 | 15 | |
| Comparative Example 2-9 | 10300 | 1.71 | 91 | 16 | 94 | 78 | 15 | |
| Comparative Example 2-10 | 10100 | 1.72 | 89 | 16 | 92 | 76 | 14 | |
| Comparative Example 2-11 | 10300 | 1.73 | 89 | 16 | 93 | 77 | 14 | |
| Comparative Example 2-12 | 9800 | 1.73 | 90 | 15 | 93 | 78 | 13 | |
| Comparative Example 2-13 | 10000 | 1.71 | 88 | 16 | 90 | 74 | 17 | |
| Comparative Example 2-14 | 10100 | 1.72 | 88 | 17 | 91 | 74 | 16 | |
| Comparative Example 2-15 | 10200 | 1.73 | 87 | 15 | 90 | 75 | 15 | |
| Comparative Example 2-16 | 9900 | 1.75 | 87 | 17 | 91 | 74 | 16 | |
| Comparative Example 2-17 | 9800 | 1.78 | 87 | 17 | 91 | 74 | 16 | |
| Comparative Example 2-18 | 9700 | 1.77 | 88 | 16 | 90 | 74 | 15 | |

### [Example 3-1 and Synthesis of Copolymer 3-1]

MEK (96.4 g) was added to a 300 mL three-neck flask, and the internal temperature was increased to 80°C. Subsequently, a mixed solution of MA-4FHB-OH (6.6 g, 20 mmol), 4FIP-M (10.8 g, 40 mmol), 1-methylcyclopentyl methacrylate (6.7 g, 40 mmol), and MEK (24.1 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 20.1 g of a white powder. A copolymer 3-1 according to Example 3-1 was synthesized through the above steps.

### [Example 3-2 and Synthesis of Copolymer 3-2]

MEK (99.7 g) was added to a 300 mL three-neck flask, and the internal temperature was increased to 80°C. Subsequently, a mixed solution of MA-4FHB-OH (6.6 g, 20 mmol), 4FIP-M (10.8 g, 40 mmol), 1-ethylcyclopentyl methacrylate (7.3 g, 40 mmol), and MEK (24.7 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 22.1 g of a white powder. A copolymer 3-2 according to Example 3-2 was synthesized through the above steps.

### [Example 3-3 and Synthesis of Copolymer 3-3]

MEK (106.9 g) was added to a 300 mL three-neck flask, and the internal temperature was increased to 80°C. Subsequently, a mixed solution of MA-4FHB-OH (6.6 g, 20 mmol), 4FIP-M (10.8 g, 40 mmol), 2-methyl-2-adamantyl methacrylate (9.4 g, 40 mmol), and MEK (26.7 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 23.3 g of a white powder. A copolymer 3-3 according to Example 3-3 was synthesized through the above steps.

### [Example 3-4 and Synthesis of Copolymer 3-4]

MEK (109.7 g) was added to a 300 mL three-neck flask, and the internal temperature was increased to 80°C. Subsequently, a mixed solution of MA-4FHB-OH (6.6 g, 20 mmol), 4FIP-M (10.8 g, 40 mmol), 2-ethyl-2-adamantyl methacrylate (9.9 g, 40 mmol), and MEK (27.3 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 24.8 g of a white powder. A copolymer 3-4 according to Example 3-4 was synthesized through the above steps.

### [Example 3-5 and Synthesis of Copolymer 3-5]

MEK (83.1 g) was added to a 300 mL three-neck flask, and the internal temperature was increased to 80°C. Subsequently, a mixed solution of MA-4FHB-OH (6.6 g, 20 mmol), 4FIP-M (10.8 g, 40 mmol), methacrylic acid (3.4 g, 40 mmol), and MEK (20.8 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 17.5 g of a white powder. A copolymer 3-5 according to Example 3-5 was synthesized through the above steps.

### [Comparative Example 3-1 and Synthesis of Comparative Copolymer 3-1]

MEK (96.4 g) was added to a 300 mL three-neck flask, and the internal temperature was increased to 80°C. Subsequently, a mixed solution of MA-BTHB-OH (5.9 g, 20 mmol), HFIP-M (9.4 g, 40 mmol), 1-methylcyclopentyl methacrylate (6.7 g, 40 mmol), and MEK (22.0 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 16.1 g of a white powder. A comparative copolymer 3-1 according to Comparative Example 3-1 was synthesized through the above steps.

### [Comparative Example 3-2 and Synthesis of Comparative Copolymer 3-2]

MEK (90.4 g) was added to a 300 mL three-neck flask, and the internal temperature was increased to 80°C. Subsequently, a mixed solution of MA-BTHB-OH (5.9 g, 20 mmol), HFIP-M (9.4 g, 40 mmol), 1-ethylcyclopentyl methacrylate (7.3 g, 40 mmol), and MEK (22.6 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 16.4 g of a white powder. A comparative copolymer 3-2 according to Comparative Example 3-2 was synthesized through the above steps.

### [Comparative Example 3-3 and Synthesis of Comparative Copolymer 3-3]

MEK (98.7 g) was added to a 300 mL three-neck flask, and the internal temperature was increased to 80°C. Subsequently, a mixed solution of MA-BTHB-OH (5.9 g, 20 mmol), HFIP-M (9.4 g, 40 mmol), 2-methyl-2-adamantyl methacrylate (9.4 g, 40 mmol), and MEK (24.7 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 18.0 g of a white powder. A comparative copolymer 3-3 according to Comparative Example 3-3 was synthesized through the above steps.

### [Comparative Example 3-4 and Synthesis of Comparative Copolymer 3-4]

MEK (100.9 g) was added to a 300 mL three-neck flask, and the internal temperature was increased to 80°C. Subsequently, a mixed solution of MA-BTHB-OH (5.9 g, 20 mmol), HFIP-M (9.4 g, 40 mmol), 2-ethyl-2-adamantyl methacrylate (9.9 g, 40 mmol), and MEK (25.2 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 18.9 g of a white powder. A comparative copolymer 3-4 according to Comparative Example 3-4 was synthesized through the above steps.

### [Comparative Example 3-5 and Synthesis of Comparative Copolymer 3-5]

MEK (75.2 g) was added to a 300 mL three-neck flask, and the internal temperature was increased to 80°C. Subsequently, a mixed solution of MA-BTHB-OH (5.9 g, 20 mmol), HFIP-M (9.4 g, 40 mmol), methacrylic acid (3.4 g, 40 mmol), and MEK (18.8 g) was added dropwise to the flask over 30 minutes, and the mixture was stirred at an internal temperature of 80°C for five hours. After the temperature was returned to room temperature, the MEK was removed by evaporation under reduced pressure to give a 50 wt% solution, and MeOH (20 g) was added to the solution. The resulting solution was then added dropwise to heptane (200 g), followed by reprecipitation and filtration to obtain a polymer. The polymer was dried under reduced pressure to obtain 14.5 g of a white powder. A comparative copolymer 3-5 according to Comparative Example 3-5 was synthesized through the above steps.

**[Table 3]**

| | Polymerizable monomer (mol%) | | | | | | | | | Mw | PDI | Contact angle (°) | | | | Sliding angle (1) |
|---|---|---|---|---|---|---|---|---|---|---|---|---|---|---|---|---|
| | MA-4FHB-OH | MA-BTHB-OH | 4FIP-M | HFIP-M | 1-Methylcyclopentyl methacrylate | 1-Ethylcyclopentyl methacrylate | 2-Methyl-2-adamantyl methacrylate | 2-Ethyl-2-adamantyl methacrylate | Methacrylic acid | | | Static | Hysteresis (Advancing - Receding) | Advancing | Receding | |
| Example 3-1 | 20 | - | 40 | - | 40 | - | - | - | - | 9900 | 1.73 | 96 | 10 | 99 | 89 | 10 |
| Example 3-2 | 20 | - | 40 | - | - | 40 | - | - | - | 10100 | 1.72 | 94 | 11 | 97 | 86 | 11 |
| Example 3-3 | 20 | - | 40 | - | - | - | 40 | - | - | 10200 | 1.74 | 94 | 11 | 98 | 87 | 10 |
| Example 3-4 | 20 | - | 40 | - | - | - | - | 40 | - | 10000 | 1.72 | 93 | 11 | 97 | 86 | 11 |
| Example 3-5 | 20 | - | 40 | - | - | - | - | - | 40 | 9800 | 1.73 | 88 | 12 | 97 | 85 | 11 |
| Comparative Example 3-1 | - | 20 | - | 40 | 40 | - | - | - | - | 9800 | 1.75 | 92 | 15 | 95 | 80 | 15 |
| Comparative Example 3-2 | - | 20 | - | 40 | - | 40 | | - | - | 10000 | 1.76 | 90 | 16 | 93 | 77 | 15 |
| Comparative Example 3-3 | - | 20 | - | 40 | - | - | 40 | - | - | 10100 | 1.77 | 88 | 16 | 92 | 76 | 15 |
| Comparative Example 3-4 | - | 20 | - | 40 | - | - | - | 40 | - | 9900 | 1.75 | 88 | 17 | 91 | 74 | 16 |
| Comparative Example 3-5 | - | 20 | - | 40 | - | - | - | - | 40 | 9700 | 1.75 | 82 | 20 | 85 | 65 | 20 |

The obtained copolymers were measured by GPC. Tables 1, 2, and 3 show the results.

### <Water Repellency Evaluation>

One gram of each copolymer was added to PGMEA (3 g) to prepare a composition. Thereafter, the composition was applied onto a 4-inch silicon substrate by a spinner and dried on a hot plate heated to 80°C for three minutes to form a film having a film thickness of 2 to 3 µm. It should be noted that the film thickness is the thickness of the film for evaluating water repellency, and actually the formed film is thicker than a non-topcoat resist film or upper layer film.

### [Measurement of Static Contact Angle]

A water droplet was placed on the film on the silicon substrate, and the static contact angle was measured by the droplet method using a contact angle meter (manufactured by Kyowa Interface Science Co., Ltd.). Herein, the static contact angle refers to the angle formed with the film surface when a water droplet is placed onto the film surface. Tables 1, 2, and 3 show the results.

### [Measurement of Hysteresis (Dynamic Advancing Angle - Dynamic Receding Angle)]

A water droplet was placed on the film on the silicon substrate, and the hysteresis (dynamic advancing angle - dynamic receding angle) was measured by the extension/contraction method using a contact angle meter (manufactured by Kyowa Interface Science Co., Ltd.). Herein, the dynamic receding angle refers to the contact angle when the water droplet is aspirated using a needle or the like so that the droplet contracts, the dynamic advancing angle refers to the contact angle when the water droplet is dispensed using a needle or the like so that the droplet expands, and the hysteresis refers to the difference between the dynamic contact angle and the dynamic receding angle. Tables 1, 2, and 3 show the results.

### [Measurement of Sliding Angle]

A water droplet (50 µL) was placed on the film on the silicon substrate, and the sliding angle was measured using a contact angle meter (manufactured by Kyowa Interface Science Co., Ltd.). The sliding angle refers to the angle of inclination of the silicon substrate at which the water droplet starts to move. Tables 1, 2, and 3 show the results.

The results in Table 1 demonstrate that the use of the copolymer 1-1 to copolymer 1-18 according to Example 1-1 to Example 1-18, respectively, exhibited lower hystereses with respect to water (immersion fluid) and lower sliding angles as compared to the use of the comparative copolymer 1-1 to comparative copolymer 1-18 according to Comparative Example 1-1 to Comparative Example 1-18, respectively.

Moreover, the results in Table 2 demonstrate that the copolymer 2-1 to copolymer 2-18 according to Example 2-1 to Example 2-18, respectively, exhibited lower hystereses and lower sliding angles as compared to the comparative copolymer 2-1 to comparative copolymer 2-18 according to Comparative Example 2-1 to Comparative Example 2-18, respectively.

Furthermore, the results in Table 3 demonstrate that the copolymer 3-1 to copolymer 3-5 according to Example 3-1 to Example 3-5, respectively, exhibited lower hystereses and lower sliding angles as compared to the comparative copolymer 3-1 to comparative copolymer 3-5 according to Comparative Example 3-1 to Comparative Example 3-5, respectively.

In high-speed exposure using an exposure apparatus, if the film formed has a low hysteresis (advancing contact angle - receding contact angle) with respect to the immersion fluid and a low sliding angle, the immersion fluid drains well during exposure, which decreases the likelihood of patterning failure. Thus, it is demonstrated that the copolymers according to the examples are useful in films formed in liquid immersion lithography.

### <Alkaline Developer Solubility Evaluation>

Each of the copolymer 1-1 to copolymer 1-18 and the comparative copolymer 1-1 to comparative copolymer 1-18 (1 g) was added to PGMEA (3 g) to prepare a composition. Then, the composition was applied onto a 4-inch silicon substrate by a spinner and dried on a hot plate heated to 80°C for three minutes to form a film having a film thickness of 3 µm. Thereafter, the film was immersed in a 2.38 wt% aqueous solution of tetramethylammonium hydroxide (TMAH) for one minute to observe whether the film on the silicon substrate was soluble in the TMAH aqueous solution. Table 1 shows the results.

As shown in Table 1, the films formed from the copolymer 1-1 to copolymer 1-18 exhibited alkaline developer solubilities comparable to those of the films formed from the comparative copolymer 1-1 to comparative copolymer 1-18.

## Claims

1. A copolymer, comprising:
a repeating unit derived from a compound having a polymerizable carbon-carbon double bond, and
a repeating unit represented by the following formula (1): 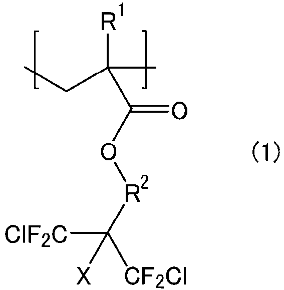 wherein R¹ is a hydrogen atom, a fluorine atom, a chlorine atom, or a C1-C10 linear or C3-C10 branched alkyl group, some or all of hydrogen atoms bonded to carbon atoms in the alkyl group being optionally replaced by fluorine atoms;
R² is a single bond, an alkylene group optionally having a linear, branched, or cyclic structure, an aromatic ring, an ester, a carbonyl, an ether, an amide, an amine, or a composite substituent thereof, a part of which is optionally fluorinated, chlorinated, or both fluorinated and chlorinated; and
X is a hydroxy group, an alkoxy group, or a hydrogen atom.

2. The copolymer according to claim 1,
wherein the repeating unit represented by formula (1) comprises a repeating unit represented by the following formula (2):

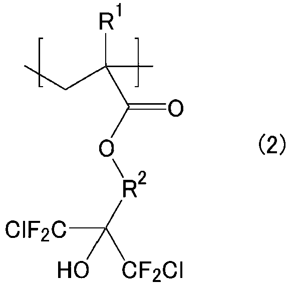

3. The copolymer according to claim 2,
wherein the repeating unit represented by formula (2) comprises a repeating unit represented by the following formula (2-1):

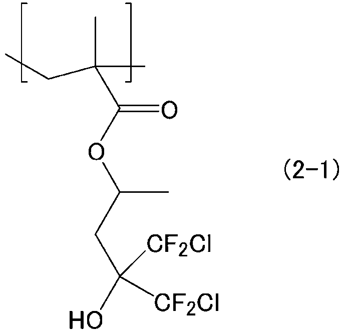

4. The copolymer according to claim 1,
wherein the repeating unit represented by formula (1) comprises a repeating unit represented by the following formula (3):

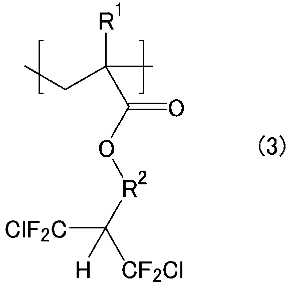

5. The copolymer according to claim 4,
wherein the repeating unit represented by formula (3) comprises a repeating unit represented by the following formula (3-1):

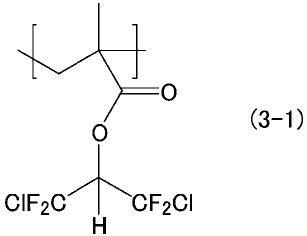

6. The copolymer according to claim 1,
wherein the repeating unit derived from a compound having a polymerizable carbon-carbon double bond comprises a repeating unit represented by the following formula (4): 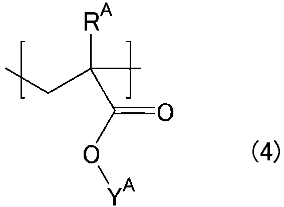 wherein R^{A} is a hydrogen atom, a fluorine atom, a chlorine atom, or a C1-C10 linear or C3-C10 branched alkyl group, some or all of hydrogen atoms bonded to carbon atoms in the alkyl group being optionally replaced by fluorine atoms; and
Y^{A} is a monovalent organic group.

7. The copolymer according to claim 6,
wherein the repeating unit represented by formula (4) comprises a repeating unit containing no fluorine atom.

8. The copolymer according to claim 6,
wherein the repeating unit represented by formula (4) comprises at least one repeating unit derived from at least one compound having a polymerizable carbon-carbon double bond selected from the group consisting of methyl methacrylate, ethyl methacrylate, n-propyl methacrylate, isopropyl methacrylate, n-butyl methacrylate, isobutyl methacrylate, t-butyl methacrylate, pentyl methacrylate, methyl acrylate, ethyl acrylate, n-propyl acrylate, isopropyl acrylate, n-butyl acrylate, isobutyl acrylate, t-butyl acrylate, pentyl acrylate, a compound represented by the following formula (4'-1), a compound represented by the following formula (4'-2), a compound represented by the following formula (4'-3), a compound represented by the following formula (4'-4), a compound represented by the following formula (4'-5), a compound represented by the following formula (4'-6), a compound represented by the following formula (4'-7), a compound represented by the following formula (4'-8), a compound represented by the following formula (4'-9), a compound represented by the following formula (4'-10), a compound represented by the following formula (4'-11), a compound represented by the following formula (4'-12), a compound represented by the following formula (4'-13), a compound represented by the following formula (4'-14), a compound represented by the following formula (4'-15), and a compound represented by the following formula (4'-16):

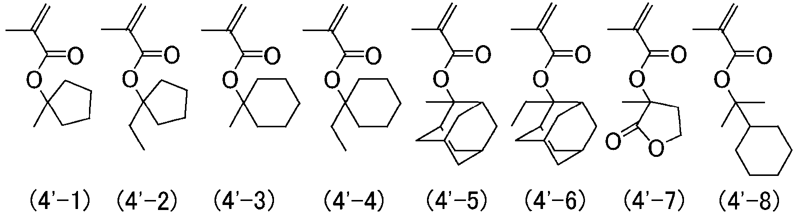

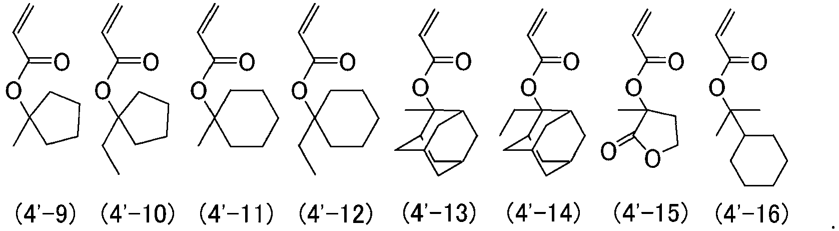

9. A polymer for a water repellent, comprising a repeating unit represented by the following formula (1): 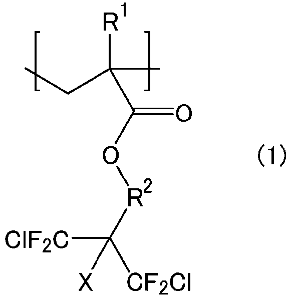 wherein R¹ is a hydrogen atom, a fluorine atom, a chlorine atom, or a C1-C10 linear or C3-C10 branched alkyl group, some or all of hydrogen atoms bonded to carbon atoms in the alkyl group being optionally replaced by fluorine atoms;
R² is a single bond, an alkylene group optionally having a linear, branched, or cyclic structure, an aromatic ring, an ester, a carbonyl, an ether, an amide, an amine, or a composite substituent thereof, a part of which is optionally fluorinated, chlorinated, or both fluorinated and chlorinated; and
X is a hydroxy group, an alkoxy group, or a hydrogen atom.

10. The polymer for a water repellent according to claim 9,
wherein the repeating unit represented by formula (1) comprises a repeating unit represented by the following formula (2):

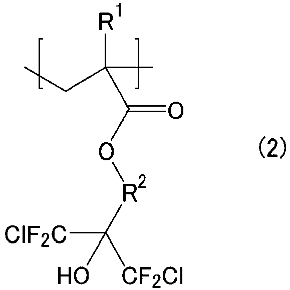

11. The polymer for a water repellent according to claim 10,
wherein the repeating unit represented by formula (2) comprises a repeating unit represented by the following formula (2-1):

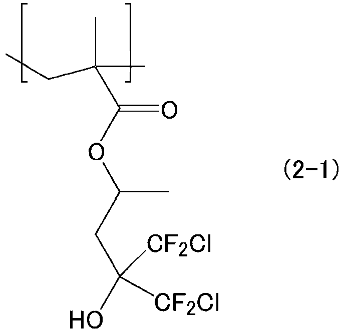

12. The polymer for a water repellent according to claim 9,
wherein the repeating unit represented by formula (1) comprises a repeating unit represented by the following formula (3):

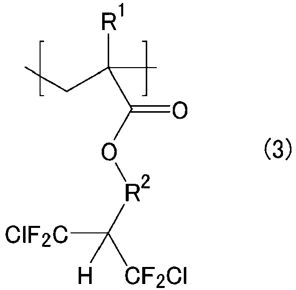

13. The polymer for a water repellent according to claim 12,
wherein the repeating unit represented by formula (3) comprises a repeating unit represented by the following formula (3-1):

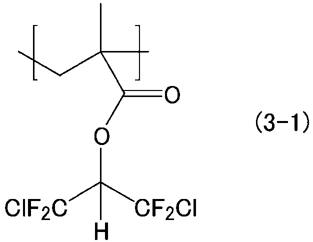

14. A composition for forming a water-repellent film, comprising the copolymer according to any one of claims 1 to 8 or the polymer for a water repellent according to any one of claims 9 to 13.

15. The composition for forming a water-repellent film according to claim 14, comprising two or more types of copolymers according to any one of claims 1 to 8 or polymers for a water repellent according to any one of claims 9 to 13.

16. The composition for forming a water-repellent film according to claim 14, further comprising an acid generator.

17. A resin film, comprising a coating film of the composition for forming a water-repellent film according to claim 14.

18. The resin film according to claim 17 for use in liquid immersion lithography.

19. A method for forming a resist pattern, comprising:
a film formation step including applying the composition for forming a water-repellent film according to claim 14 to a surface of a substrate or a lower layer film to form a resin film; and
a liquid immersion lithography step including exposing the resin film with a surface in direct contact with water to electromagnetic waves or high-energy rays having a wavelength of 300 nm or less through the water.
